(19) Europäisches Patentamt
European Patent Office
Office européen des brevets

(11) EP 4 611 044 A1

(12) EUROPEAN PATENT APPLICATION
published in accordance with Art. 153(4) EPC

(43) Date of publication:
**03.09.2025 Bulletin 2025/36**

(21) Application number: **23882179.7**

(22) Date of filing: **28.07.2023**

(51) International Patent Classification (IPC):
***H01L 29/78*** ***(2006.01)*** ***H01L 21/205*** ***(2006.01)***
***H01L 21/336*** ***(2006.01)***

(52) Cooperative Patent Classification (CPC):
**H01L 21/2015; H10D 30/021; H10D 30/60**

(86) International application number:
**PCT/JP2023/027740**

(87) International publication number:
**WO 2024/089963 (02.05.2024 Gazette 2024/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.10.2022 JP 2022170586**

(71) Applicant: **Takamizawa, Shoichi**
**Takasaki-shi, Gunma 370-0045 (JP)**

(72) Inventor: **Takamizawa, Shoichi**
**Takasaki-shi, Gunma 370-0045 (JP)**

(74) Representative: **Mincone, Antimo**
**Viale Europa 101**
**50126 Firenze (IT)**

# (54) METHOD FOR PRODUCING SEMICONDUCTOR ELEMENT HAVING SUPER JUNCTION STRUCTURE

(57) Provided is a method of filling trenches that are formed in a silicon substrate so as to have a narrow opening width and a high aspect ratio by fast epitaxial growth with blocking of an opening portion prevented. On the silicon substrate in which the trenches having a high aspect ratio are formed, the trenches are filled by epitaxial growth at a high growth rate within a range in which the blocking is avoided, by setting a growth temperature to a range of from 950°C to 1,050°C so as not to cause blocking in the trench opening portion by selective epitaxial growth, and by adding hydrogen chloride gas in an amount corresponding to the aspect ratio of the trenches to a reaction gas which uses high-concentration silane chloride as a silicon source.

Fig.1

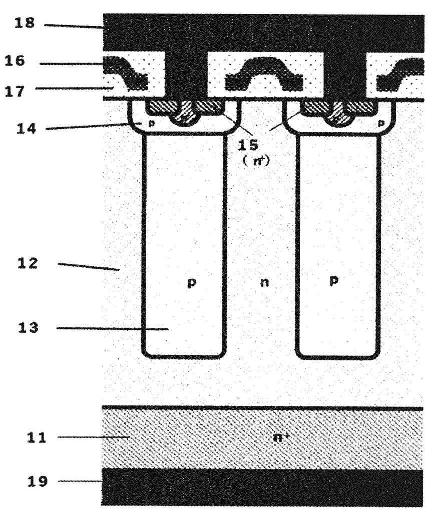


EP 4 611 044 A1

## Description

[Technical Field]

The present invention relates to a method of manufacturing a semiconductor substrate in which a large number of deep trenches are formed in a stripe pattern in a silicon substrate (a silicon wafer with a mirror-finish surface), and are filled back with a silicon epitaxial growth layer of a conductivity type different from the conductivity type of the substrate.

[Background Art]

With technological advancement of power MOSFETs, a super junction MOSFET (SJMOS) which has a low ON-resistance characteristic with respect to a withstand voltage by forming a large number of pn columns in a stripe pattern in a silicon substrate is being put to practice use, mainly in high-withstand voltage products around 600 V at which an effect of decreasing ON resistance is prominent. Methods of manufacturing a super junction (SJ) structure include a multi-epitaxial growth method in which, after a step of growing a thin epitaxial layer of the same conductivity type as the conductivity type of a silicon substrate and a photolithography step, a step of implanting a dopant of a conductivity type different from the conductivity type of the substrate by ion implantation and growing a thin epitaxial layer of the same conductivity type as the conductivity type of the substrate again is repeated many times, and a deep trench method (hereinafter noted as trench filling method) in which a deep trench is formed in a silicon substrate by dry etching, and epitaxial growth of a conductivity type different from the conductivity type of the substrate is performed to fill back the trench. For a time, development of SJMOSs by the trench filling method which is a simple manufacturing method and which is easy to form a minute trench has energetically been pursued. However, there is a problem of void generation in which, when the silicon substrate with the trench formed therein (hereinafter noted as trench substrate) is buried by epitaxial growth, a trench opening portion is blocked and a void is consequently generated. In order to avoid the void generation, the growth is required to be slowed down, and, due to a resultant marked drop in productivity, practical application thereof is limited.

In contrast, in the multi-epitaxial growth method, the pn columns are formed by repeating the growth of a thin epitaxial layer and the photolithography method alternatingly with ion implantation and, accordingly, individual manufacturing steps are technologically established. However, in order to form the minute pn columns, the step of forming a thin epitaxial growth layer and the step of performing ion implantation are required to be repeated many times until a thickness of the pn column region reaches a thickness corresponding to a withstand voltage of an element. Consequently, a manufacturing process is markedly long and complicated, which results in a problem of an increased cost.

The current situation of the multi-epitaxial growth method is that a cost of manufacturing an epitaxial layer per unit area has been cut in half owing to: a widespread use of a $p/p^+$-type epitaxial substrate as a silicon substrate for a cutting-edge logic CMOS IC; quality improvement and cost reduction as a result of an improvement of a single-wafer epitaxial apparatus and advancement of an epitaxial growth process technology for a growth to a thickness of from 3 $\mu$m to 5 $\mu$m; and start of use of a substrate that is 300 mm in diameter in manufacture of an SJMOS by the multi-epitaxial growth method. Due to that background and the lack of technological development of an approach to the trench filling method that achieves efficient filling of a minute trench and avoidance of void generation at the same time, most SJMOSs are produced by the multi-epitaxial growth method at present.

A void generated in a trench causes a drop in withstand voltage and an increase in leak current. Accordingly, a technological challenge of the trench filling method is to figure out how to fill a trench without generating a void in the trench. When a trench is filled by epitaxial growth, a trench opening portion is blocked to readily cause void generation, and a countermeasure therefor is the biggest challenge. In early days, a method in which a trench opening portion that is about to be blocked is widened by etch-back with use of hydrogen chloride gas in the middle of filling, and then the filling step is resumed has been employed, but has been very poor in productivity. In order to improve productivity, a method that prevents the blocking by adding halide gas to a reaction gas of epitaxial growth to decrease a growth rate in the vicinity of the trench opening portion from a growth rate at a bottom portion, and a method that prevents the blocking at the opening portion by performing filling-epitaxial growth under a reaction controlling condition have been proposed at a relatively early stage (Patent Literatures 1 and 2). However, it is difficult to prevent the void generation efficiently and stably in carrying out those proposals in a concrete manner. Although many proposals have been made, contents of most of the proposals are an attempt to find out, by trial and error, an epitaxial growth condition that causes no void generation, and there has been substantially no proposal for solving the problem of low productivity (Patent Literature 5 [0008]).

Some approaches to the trench filling method allow generation of a void at a position at which electrical characteristics of the SJMOS are hardly affected by the generation of the void to develop a process technology in which the epitaxial growth rate is relatively fast, and are being used to manufacture a product in a fairly large scale. Large-scale selling of a product is becoming a reality, with a certain degree of productivity secured by selecting a crystal orientation and devising a process in a manner that avoids void generation in a superficial portion in which a void invites degradation of element characteristics and causes a significant trouble in a manufacturing process. However, those approaches are limited in terms of dealing with miniaturization, and have not succeeded in advancing miniaturization further than the level of miniaturization in the multi-epitaxial growth method (Patent Literature 4).

From around the year 2010, forming a thin epitaxial layer and stacking multiple thin epitaxial layers by the multi-epitaxial growth method have been started to be used to achieve miniaturization and lowering of ON resistance of an SJMOS, and development of a state-of-the-art SJMOS product by the trench filling method is hardly being addressed. As for the multi-epitaxial growth method, miniaturization and lowering of ON resistance are being achieved by forming a thin epitaxial layer and increasing the number of thin epitaxial layers to about fifteen. The miniaturization is becoming close to the limit in view of such issues as complication of the process and diffusion in a lateral direction of an ion implantation layer. Accordingly, although transition to a size that is 200 mm in diameter remains as a challenge, an actual situation is that focus of development of next-generation products has shifted to a high-performance power semiconductor by way of an element that uses a new material such as SiC or GaN-on-Si.

In any case, it is obvious that needs for silicon-based power MOSs are going to increase ever more, with MOSs for inverters at the center. Performance improvement, cost reduction, and energy saving are required to be advanced not only of state-of-the-art MOSs but also of general-purpose MOSs. SJMOSs are being used mainly in products having a withstand voltage of around 600 V and, whereas application of the multi-epitaxial growth method to a low-withstand voltage power MOS of around 100 V is difficult, the trench filling method is applicable. Now that the focus of development has shifted to SiC, GaN-on-Si and the like, in view of performance improvement of all future power MOSs that use a silicon substrate, possibilities of trench filling-type SJMOSs are worth being re-examined from scratch and, if there is any possibility, it is considered to be necessary to make efforts for preventing the technology from being forgotten.

[Citation List]

[Patent Literature]

[PTL 1]
JP 3915984 B2
[PTL 2]
JP 4773716 B2
[PTL 3]
JP 4879545 B2
[PTL 4]
JP 5072221 B2
[PTL 5]
JP 5702622 B2

[Non Patent Literature]

[NPL 1]
S. Yamauchi, et. al, Proc. ISPSD 2001, p. 363

[Summary of Invention]

[Technical Problem]

High performance of an SJMOS in terms of ON resistance characteristic is achieved by miniaturization of the element (see FIG. 2). However, the multi-epitaxial growth method and the trench filling method both have issues with regards to miniaturization. While the multi-epitaxial growth method has a predictable, specific limit to miniaturization, with the trench filling method, how minute a trench can be filled without generating a void depends on a trench filling epitaxial technology. With the multi-epitaxial growth method, twelve or more thin epitaxial layers are required to be stacked to a required thickness in a product that has a withstand voltage of around 600 V, whereas epitaxial growth in the trench filling method is required to be performed once as long as a minute trench is easily filled by epitaxial growth. Accordingly, in a case in which easy filling of a minute trench by epitaxial growth is achieved, the trench filling method surely becomes a main choice as a method of manufacturing an SJMOS that is low in ON resistance. However, a technological hurdle to avoidance of defective filling (a void) of a trench portion is higher than expected, resulting in a long-lasting situation in which no advancement of manufacturing process is observed. Meanwhile, a cost of flat epitaxial growth to a thickness of from 3 μm to 5 μm for a logic CMOS is decreasing and, consequently, most SJMOS products supplied today use the multi-epitaxial growth method. Before development of the trench filling method is terminated, nature of the high technological hurdle is required to be thoroughly analyzed and examined.

The trench filling method is considered to be rooted from Non-Patent Literature 1 in which deep trench isolation and a technology of filling a trench capacitor of a DRAM with polysilicon by LPCVD are developed into the trench filling epitaxial technology. In order to achieve epitaxial growth, a growth temperature is raised to from 650°C to 850°C, and a growth pressure is raised to from $10^3$ Pa to $10^5$ Pa. The growth rate in the vicinity of the trench opening portion consequently increases, and the accelerated growth rate promotes blocking. This is dealt with by raising the temperature to 1,000°C or higher in the middle of the growth, performing etch back with the use of hydrogen chloride gas to widen the trench opening portion, and then lowering the temperature for resumption of growth. A trench depth and an aspect ratio are set to 40 μm and 12, respectively, to aim for characteristics that exceed characteristics obtained in an advanced approach to the multi-epitaxial growth method, and possibilities of the trench filling method are presented. However, minute voids remain in the bottom portion of the trench despite annealing performed at a high temperature in a hydrogen atmosphere in the last step, and the issue of low productivity remains as well due to the use of an RTA apparatus.

Solving the problem of void generation has been a priority for the trench filling method because a void generated in a trench when the trench is being filled by epitaxial growth leads to poor electrical characteristics of the element and causes a trouble in a manufacturing process. As a technological measure for solving the problem of void generation, an approach to the trench filling method in which halide gas is added to a reaction gas of epitaxial growth to hinder etching and epitaxial growth in the vicinity of the trench opening portion, and the growth rate in the vicinity of the trench opening portion is thus decreased from a growth rate in the bottom portion to prevent the blocking has been proposed at an early stage (Patent Literatures 1 and 2). That the void generation in the trench portion can be suppressed to a certain degree by adding hydrogen chloride gas to a growth gas is shown by concrete results. However, how the halide gas added to the growth gas contributes to the suppression of void generation has not been checked quantitatively, and there has been no attempt to understand the phenomenon in principle for further technological advancement.

Patent Literatures 1 and 2 mentioned above also include a proposal in which filling epitaxial growth is performed under a reaction controlling condition in order to improve a quality of trench filling. Although presentation of specific Examples in which the blocking of the opening portion is prevented by adding hydrogen chloride gas is included along with case descriptions, no explanation of a principle is included with regards to specific methods and effectiveness of performing trench filling epitaxial growth as reaction controlled growth. An optimum trench filling epitaxial condition is determined by trial and error as seen in Patent Literature 5, and determining the optimum condition by setting many parameters is a laborious procedure. A way to further narrow down a range in which the optimum condition resides is required to be figured out.

In an SJMOS, low ON resistance is achieved by setting a trench opening width and a pitch between stripes of the pn columns narrow. However, in trial manufacture that has been executed, the speed of filling epitaxial growth has ended up being required to be greatly decreased in order to fabricate an SJ structure by filling a trench that is minute and high in aspect ratio by way of epitaxial growth and simultaneously suppressing void generation. Main contents of proposals that have been made up to now on a trench filling SJMOS manufacturing method in the form of a patent publication are techniques of preventing void generation, and substantially no proposals mention a technique for shortening a filling epitaxial growth time. In a case in which a specific time is presented, the filling epitaxial growth time is reported to be from 60 minutes to 200 minutes, depending on conditions (Patent Literature 3), but clear reports on the growth time in Examples are hardly found. A proposal of a technology that achieves prevention of void generation and shortening of a deposition time at the same time in epitaxial growth for filling a minute trench is waited for.

In view of the situations described above, an object of the present invention is to provide a specific method of manufacturing a high-performance, trench filling-type SJMOS at a low cost, based on a consideration about whether a trench that is high in aspect ratio and more minute than a level achieved by the multi-epitaxial growth method can be filled by an epitaxial growth method under a high growth rate condition, with void generation suppressed, with use of a single-wafer (-type) epitaxial apparatus widely used at present, through a quantitative discussion based on an epitaxial reaction mechanism, not through a qualitative discussion as in the proposals that have been made up to now in the form of a patent publication.

[Solution to Problem]

In order to attain the object described above, the invention according to claim 1 is a method of manufacturing a semiconductor element having a super junction structure which uses a selective epitaxial growth method by a single-wafer reactor in manufacture of the super junction structure in which trenches formed in a stripe pattern in a silicon substrate are filled with an epitaxial layer having a conductivity type different from a conductivity type of the silicon substrate, and the method includes:

a first preparation step including: setting a condition under which epitaxial growth on a low-resistance silicon substrate

1 having the same crystal orientation as a crystal orientation of the silicon substrate in which the trenches are formed is stable, fast and diffusion controlled growth; obtaining, from flow rate conditions of a silicon source gas and a carrier hydrogen gas of a reaction gas in the set condition and a growth rate at a temperature of the set condition, a molar quantity of a silicon source supplied per unit time to a unit surface of the silicon substrate; and further obtaining, through calculation, a supply amount of the silicon source at each temperature when a growth temperature alone is changed;

a second preparation step including: lowering, without changing the flow rate conditions of the reaction gas, a temperature of selective epitaxial growth for filling the trenches which are formed in the silicon substrate and which have an aspect ratio A to 1,000±50°C, which is a favorable temperature; obtaining, through calculation, an epitaxial growth rate at which a molar quantity of the source consumed per unit time by epitaxial growth for filling the trenches that have the aspect ratio A in a region of the unit surface at the favorable temperature is prevented from exceeding the molar quantity obtained in the first preparation step as the molar quantity of the source supplied to the unit surface of the silicon substrate per unit time; and figuring out a flow rate at which hydrogen chloride gas is added to the reaction gas in a manner that sets a rate of selective epitaxial growth performed at the favorable temperature of growth, with the hydrogen chloride gas added under the condition of the reaction gas, on a low-resistance silicon substrate 2 having the same crystal orientation as the crystal orientation of the silicon substrate in which the trenches are formed, to the epitaxial growth rate obtained through the calculation; and

filling the trenches formed in the silicon substrate by a selective epitaxial growth method that uses the condition of the reaction gas and the favorable temperature of growth that are set in the first preparation step and the second preparation step and a condition of the hydrogen chloride gas addition flow rate figured out in the second preparation step, to thereby perform reaction controlled epitaxial growth in which an amount of the silicon source consumed on the unit surface of a trench portion is exceeded by the supply amount of the source, and thus fill the trenches at a fast growth rate within a range in which no voids are generated. The molar quantity of the silicon source supplied to the substrate per unit time can be figured out by setting a fast epitaxial growth condition that satisfies a diffusion controlling condition, and, when the figured-out molar quantity is large, reaction controlled growth that is fast is possible. In the unit surface of the substrate in which the trenches are formed by machining, an area in which epitaxial growth is performed increases substantially in proportion to the aspect ratio, relative to the area of epitaxial growth on a silicon substrate having a flat surface, and a range of the reaction controlling condition accordingly becomes narrow. A growth rate range in which the reaction controlling condition is satisfied at a relatively high temperature in selective epitaxial growth is known, and gist thereof is to use a condition that sets as high a growth rate as possible. (See FIGS. 6)

The invention according to claim 2 is an example of the method of manufacturing a semiconductor element having a super junction structure according to claim 1, in which the first preparation step includes setting a reaction gas flow rate condition G1 about a flow rate of the silicon source gas and a flow rate of the hydrogen carrier gas so that a growth rate X μm/min is 3.0 μm/min or more and 5.0 μm/min or less at a growth temperature T1°C within a range of from 1,100°C to 1,150°C in which epitaxial growth on the low-resistance silicon substrate 1 having the same crystal orientation as the crystal orientation of the silicon substrate is a diffusion controlled reaction, and the second preparation step includes setting an epitaxial growth temperature T2°C for filling the trenches having the aspect ratio A without changing the reaction gas flow rate condition G1 within a range of 1,000±50°C, and obtaining the hydrogen chloride gas addition flow rate as a flow rate that sets a growth rate to $[(T1+273)/(T2+273)]^{-3/2}X/(A+1)$ μm/min or less in selective epitaxial growth performed on the low-resistance silicon substrate 2 having the same crystal plane as a crystal plane of the silicon substrate in which the trenches are formed, by adding hydrogen chloride gas to the reaction gas, and in which the trenches formed in the silicon substrate are filled by selective epitaxial growth that uses the flow rate conditions of the reaction gas, the growth temperature and the hydrogen chloride gas addition flow rate that are set in the first preparation step and the second preparation step, to thereby perform reaction controlled epitaxial growth in which the supply amount of the silicon source exceeds an amount of the silicon source consumed in all sites of each of the trenches, and thus fill the trenches by a selective epitaxial growth process free of void generation. As for the growth rate in diffusion controlled growth, the whole amount of the silicon source supplied to the substrate surface immediately enters into epitaxial reaction, and a diffusion coefficient at which the silicon source is diffused through a gas is in proportion to an absolute temperature to the power of 3/2. Accordingly, an amount of the silicon source supplied to the substrate at each temperature in diffusion controlled growth can be obtained. Increasing this silicon source supply amount enables filling of the trenches by fast epitaxial growth without generating a void.

The invention according to claim 3 is the method of manufacturing a semiconductor element having a super junction structure according to claim 2, in which, when the trenches formed in the stripe pattern in the silicon substrate to be filled by selective epitaxial growth have a pitch of 10.0 μm or less and an aspect ratio of 10 or more, a flow rate that sets the growth rate to 1.2X/(A+1) μm/min or less in selective epitaxial growth on the low-resistance silicon substrate 2 having the same crystal plane as the crystal plane of the silicon substrate in which the trenches are formed is obtained as a flow rate at which hydrogen chloride gas is added to the reaction gas in the selective epitaxial growth for filling the trenches, and the trenches formed in the silicon substrate are filled by the selective epitaxial growth performed at the obtained flow rate of addition. Claim 3 addresses a matter in which, when the pitch of stripes of the trenches becomes narrow and the aspect ratio increases, hydrogen chloride gas generated per unit area in epitaxial growth increases to render the concentration of hydrogen chloride gas on a trench substrate surface high, and a more detailed description is given in [0051] and [0052]. (See FIGS. 10, FIGS. 12 and FIG. 14)

Gist of the invention according to claim 4 is the method of manufacturing a semiconductor element having a super junction structure according to claim 1, in which the method uses the silicon substrate in which the trenches are formed by machining so that a surface of the silicon substrate and side walls of the trenches in a longitudinal direction are a (100) plane and (100) planes, respectively, or so that the surface of the silicon substrate and the side walls of the trenches are a (110) plane and (111) planes, respectively, out of combinations of crystal planes that set an epitaxial growth rate on the surface of the silicon substrate in which the trenches are formed to a rate higher than or equal to an epitaxial growth rate on crystal planes of the side walls of the trenches. In this manner, stable planes such as the (110) plane and a (310) plane are grown in the opening portion and a trench bottom portion, respectively, with the result that the chance of the blocking occurring decreases. (See FIGS. 12)

Gist of the invention according to claim 5 is the method of manufacturing a semiconductor element having a super junction structure according to claim 1, in which, in reactive ion etching for forming the trenches, a Bosch process used in deep-trench etching for a through-electrode having excellent productivity is used, minute concavities and convexities which are caused in an etched surface by the Bosch process and which are called scallops are smoothed out by setting a temperature condition of the selective epitaxial growth to 1,000±50°C, satisfying a reaction controlling condition by way of a flow rate at which hydrogen chloride gas is added, and smoothing a growth surface at an early stage of growth under an epitaxial condition that renders a scale of surface migration of the silicon source large, and the trenches are thus filled with an epitaxial layer of an excellent crystal quality free of micro-voids and misfit dislocation. With this method, extremely strict machining of taper angles on the trench side surfaces is no longer indispensable.

Gist of the invention according to claim 6 is the method of manufacturing a semiconductor element having a super junction structure which uses a trench filling epitaxial growth condition according to claim 1, in which, with progress of filling of the trenches by epitaxial growth, a growth area of the trench portion decreases to diminish a consumption amount of the silicon source per unit time, and productivity is accordingly improved by reducing an amount by which hydrogen chloride gas is added, in a manner corresponding to a change in the consumption amount within a range in which a reaction controlling condition is maintained, or by raising the growth temperature to increase a filling epitaxial growth rate and thus shorten a growth time (See FIGS. 12).

[Advantageous Effects of Invention]

It has been found out, from technological examinations, that a fact that, in epitaxial growth on a trench substrate having an aspect ratio A, a reaction area on a substrate unit surface is (A+1) times larger than on a silicon substrate having a flat surface has not hitherto been understood, and the inventor of the present invention has come to an understanding that a trench is required to be filled under a filling growth condition in a reaction controlling manner, with a silicon source supply amount increased accordingly or with a growth rate decreased accordingly. In order to address that matter, a reaction gas condition has been set and a method of setting a condition for adding hydrogen chloride gas in selective epitaxial growth has been devised so that the silicon source is supplied in as large an amount as possible per unit time in trench filling epitaxial growth. It has thus been proven that a trench of a high aspect ratio can be filled by a selective epitaxial growth method at a relatively high temperature and a relatively high speed without causing a block in a trench opening portion. It is shown here in a concrete manner that practical use of an SJMOSFET of ever higher performance is achievable by this trench filling method.

[Brief Description of Drawings]

[Fig. 1]
FIG. 1 is a schematic cross-sectional view for illustrating an example of a semiconductor apparatus according to the present invention.
[Fig. 2]
FIG. 2 is a graph for showing an example of a relationship between ON resistance and a pitch of pn columns in a super junction MOSFET.
[Fig. 3]
FIG. 3 is a flow chart for illustrating an example of a manufacturing process in which a super junction structure in the present invention is formed by trench filling epitaxial growth.

[Fig. 4]
FIG. 4 is a cross-sectional schematic view of a radiation heating-type single-wafer epitaxial growth apparatus.
[Fig. 5]
FIG. 5 is an explanatory diagram for illustrating a growth mechanism of silicon epitaxial growth on a silicon substrate.
[Fig. 6]
FIGS. 6 are conceptual diagrams for illustrating a difference between the silicon substrate (a) and a trench substrate (b) having an aspect ratio A in terms of an area of an epitaxial growth surface in a substrate unit surface (S).
[Fig. 7]
FIG. 7 is an example of an Arrhenius plot of a parallel-plate apparatus, and is a graph for showing a relationship between an amount of a silicon source supplied to a silicon substrate surface and an amount of the silicon source consumed by reaction.
[Fig. 8]
FIG. 8 is a graph for showing an example of a relationship between a growth rate and an addition flow rate of hydrogen chloride gas in selective epitaxial growth on the silicon substrate.
[Fig. 9]
FIG. 9 is a schematic flow chart of trench filling selective epitaxial growth.
[Fig. 10]
FIGS. 10 are schematic diagrams for illustrating a relationship between a shape, surface migration and a mean free path of a deposited film at step coverage of CVD.
[Fig. 11]
FIG. 11 is a diagram for illustrating changes in concentration distribution of hydrogen chloride that are caused during filling epitaxial growth using trichlorosilane as a silicon source by addition of hydrogen chloride to a supply gas.
[Fig. 12]
FIGS. 12 are conceptual diagrams for illustrating a difference in epitaxial growth in a trench opening portion depending on crystal orientations of the silicon substrate surface and a trench side wall, and a cross-sectional SEM photograph of the opening portion in the middle of growth in a case in which the crystal orientation of the surface/trench side wall is (100).
[Fig. 13]
FIGS. 13 are a schematic diagram and a cross-sectional SEM photograph that depict observation by cross-sectional SEM of a situation in which a trench is in the middle of being filled by epitaxial growth.
[Fig. 14]
FIG. 14 is a graph in which results of examining a void generation situation on a trench filling epitaxial wafer of Example by cross-sectional SEM are organized with respect to a relationship between the aspect ratio and the growth rate.

[Description of Embodiments]

A semiconductor apparatus in an embodiment of the present invention is described in many Literatures including patent Literatures.

In the following, an outline of a structure of a planar SJMOS is described. Although a trench gate SJMOS structure which is advantageous for miniaturization is recently being used, an element manufacturing process of the planar SJMOS structure only slightly differs from an element manufacturing process of the trench gate SJMOS structure in a trench filling step and subsequent processes, and no significant technological issue resides therein. Accordingly, steps after trench filling up through planarization polishing are described below.

The semiconductor apparatus in this embodiment which is illustrated in FIG. 1 has a configuration of a vertical MOSFET including a super junction structure. In this device structure, an n-type silicon epitaxial layer 12 is provided on an $n^+$-type single-crystal silicon substrate 11 as a semiconductor substrate. Further, in the n-type epitaxial layer 12, a super junction structure (SJ structure) in which p-type columns 13 and the n-type silicon layer 12 are alternately arranged in a stripe pattern is formed. In the SJ structure, an impurity concentration is determined so as to correspond to widths of the pn columns, respectively. A withstand voltage of the element is determined by a depth of the pn column region. Further, in a case in which a pitch of the pn columns can be set small, an impurity concentration of about $7\times10^{15}$ atoms/cc can be raised further to a level at which low ON resistance is achieved (FIG. 2). The p-type columns 13 are formed at a predetermined depth in proximity to the $n^+$-type silicon substrate 11, from a top surface of the n-type epitaxial layer 12. The depth thereof determines the withstand voltage of the element.

In a region right above the 13 formed in the n-type silicon layer 12, p-type base regions 14 stretching in a longitudinal direction of a trench are formed. In an upper portion of each of the p-type base regions 14, a pair of $n^+$-type source regions 15 stretching in the longitudinal direction of the trench are selectively formed so as to be spaced apart from each other. Gate electrodes 16 which are control electrodes are formed on the n-type silicon layer 12 so as to be wrapped by a gate insulating film 17. The gate electrodes 16 are normally formed from doped polysilicon. The gate insulating film 17 is formed from a silicon oxide in most cases.

The gate electrodes 16 covered with the insulating film are each formed so as to lie across the p-type base regions 14 adjacent to each other. The gate electrodes 16 are arranged so that end portions of each of the gate electrodes 16 are placed right above end portions of the source regions 15. A thickness of the oxide film below the gate electrodes 16 is thin in p-type base region portions between the source regions 15 and the n-type silicon layer 12, and is thick in portions other than the p-type base region portions. The gate electrodes 16 have a shape that protrudes upward. A source electrode 18 is provided between the gate electrodes 16, and is connected to the source regions. The source electrode 18 is formed on the gate insulating film as well to connect one source electrode to another source electrode. On a lower surface of the $n^+$-type silicon substrate 11, a drain electrode 19 is connected to the $n^+$-type silicon substrate 11. Metal is generally used for the source electrode 18 and the drain electrode 19. This basic structure also applies, in essence, to an SJMOS that has a trench gate-type gate structure.

FIG. 3 is an illustration of a flow of steps up through surface planarization polishing after trench filling in a first half of a manufacturing process of the semiconductor apparatus in this embodiment, and are schematic cross-sectional views of the wafer at stages of completion of the respective steps. A silicon substrate 1 used in manufacture of the semiconductor apparatus in the present invention may be an $n/n^+$-type silicon epitaxial substrate 1 obtained by doping the $n^+$-type silicon substrate 11 with a high concentration of phosphorus, arsenic or antimony and then growing, on the $n^+$-type silicon substrate 11, by an epitaxial growth method, the n-type epitaxial layer 12 having a resistivity of around 1 $\Omega$ cm. A surface of the silicon substrate 1 may have a plane orientation of (100). When an orientation flat orientation or a notch orientation is set to (100), crystal plane orientations of a wafer surface and a trench side wall can be unified to (100), which renders consideration for variations in epitaxial growth rate depending on the crystal plane orientation unrequired. Accordingly, the orientation flat orientation or the notch orientation in the following description is assumed to be (100). Next, a thermally oxidized film is formed and a stripe-pattern oxide film 9 is formed on the surface of the epitaxial substrate 1 by a well-known photolithography technology to be used as a mask oxide film 9 in processing of the trench by reactive ion etching (Step (b) of FIG. 3).

With the oxide film formed by the method described above as a mask, trenches 20 having a predetermined depth are formed by a dry etching method, for example, reactive ion etching (RIE) (Step (c) of FIG. 3), in order to form a pn column structure having a stripe pattern. Use of a Bosch process RIE apparatus for forming a silicon through-electrode enables forming of a minute trench having an aspect ratio of 20 or higher and an opening width of 2 $\mu$m or less at a high speed with high precision. In etching of the trenches, a polymer and damage remain, and are removed by washing, etching or the like to prevent generation of a crystal defect in epitaxial growth of the next step. With the Bosch process, minute concavities and convexities called scallops are formed on trench side surfaces. The concavities and convexities are smoothed during the epitaxial step in the present method. In a trench forming step, the oxide film 9 is used as a mask. Some methods use wet etching to remove the oxide film 9 after the trenches are formed, but the present method uses a method in which the trenches are filled by selective epitaxial growth with the oxide film 9 left. Use of this method has advantages such as avoidance of deformation in the trench opening portion even in heat treatment in a hydrogen atmosphere of 1,100°C, as well as disadvantages such as proneness to defects from thermal stress of the oxide film and silicon. With this method, an alignment mark can be left after surface polishing is performed on an over-growth layer of filling epitaxial growth, and this method is selected by taking convenience to subsequent alignment into consideration. The method that removes the mask oxide film is also selectable.

Next, the p-type filling epitaxial layers 13 are grown by vapor deposition on an epitaxial substrate 2 in which the trenches have been formed (Step (d) of FIG. 3). Specifically, the trench substrate 2 is placed in the epitaxial growth apparatus, and is subjected to heat treatment at a predetermined temperature (for example, at 1,100°C in a hydrogen atmosphere) to remove a naturally oxidized film on a silicon surface. After the removal, the temperature of the substrate is lowered to a predetermined temperature to grow the p-type filling epitaxial layers 13 by vapor deposition.

FIG. 4 is an example of a cross-sectional schematic view of a parallel-plate single-wafer epitaxial apparatus widely used for silicon substrates that are from 150 mm to 300 mm in diameter. As illustrated in FIG. 4, a vapor deposition apparatus includes a top board 22, a wafer stage for placing a silicon substrate horizontally thereon, and side wall portions, which define an upper surface, a lower surface, and side surfaces, respectively, of a reaction chamber, and is an epitaxial growth apparatus in which epitaxial growth is performed on a rotating wafer 31 placed in the reaction chamber. From a gas inlet 24 formed at one end of the vapor deposition apparatus, a reaction (raw material) gas for epitaxial growth is introduced into a reaction tube. The reaction gas is caused to flow in an inner space of the reaction tube horizontally and in one direction under a laminar flow condition, to thereby form a boundary layer 32 having a substantially constant thickness. One silicon substrate 31 is placed on a susceptor 23 of the wafer stage, and rotates together with the susceptor 23. A gas outlet 29 is formed on an opposite side from the reaction gas inlet 24. The introduced reaction gas travels above a surface of the silicon substrate at a predetermined flow rate, and then a portion of the gas that has not been consumed by epitaxial reaction and a reaction product gas are discharged from the gas outlet 29.

Here, trichlorosilane gas, for example, is usable for a silicon source gas. This trichlorosilane gas is introduced into the reaction tube by preparing a mixture gas that has a certain concentration through bubbling of hydrogen gas in liquid

trichlorosilane ($SiHCl_3$), and mixing the mixture gas with a carrier hydrogen gas, with the flow rate adjusted by a mass flow controller, to dilute the concentration to from about 3% to about 8%. As a dopant gas, a minute amount of diborane ($B_2H_6$) diluted with hydrogen gas to a certain concentration is adjusted by the mass flow controller to be similarly mixed with hydrogen gas for dilution. Further, hydrogen chloride gas is adjusted by the mass flow controller to be similarly mixed with the hydrogen gas for dilution. A reaction gas that is a mixture of those gases is fed from many inlets so that a laminar flow is readily caused in a reaction container.

The silicon substrate 31 is then driven to rotate together with the susceptor 23, and further receives a supply of the reaction gas, with halogen lamps 21 heating the silicon substrate 31 from an upper surface and a lower surface of the silicon substrate 31 to a predetermined temperature. The epitaxial layer is thus formed inside the trenches. Pressure inside the reaction container is set to be normal pressure or a slightly reduced pressure of from 730 torr to 750 torr. The present method is premised on a normal pressure condition, but it is also possible to perform epitaxial growth under a reduced pressure condition in which the pressure is reduced to about 70 torr. Trench filling epitaxial growth in the present method uses 1,000°C, which is a temperature preferred to achieve conformal growth in a trench portion. The temperature is measured mainly with a radiation thermometer 33, and is required to be corrected because a radiation factor differs on the surface on which the oxide film remains. Growth conditions can be stabilized by taking care to set the temperature as close to 1,000°C as possible, with the result that void generation is prevented.

In manufacture of a trench filling-type SJMOS of the related art, the growth rate has been required to be decreased in Step (d) of FIG. 3 in which the trenches 20 are filled by epitaxial growth, as a measure to prevent void generation due to blocking in trench opening portions 8, and low-cost production has not been achieved as a result. This step is the biggest challenge, and a specific description of the present method is accordingly given by describing, in detail, the process of a consideration that has led to establishment of a trench filling epitaxial growth technology of the present invention. First, terms are standardized to describe an epitaxial growth mechanism, a relationship between void generation and an epitaxial growth condition is described, and, at the same time, a specific description is given on a procedure that achieves maximization of the growth rate as well as prevention of void generation when trenches are filled by epitaxial growth.

An outline of a reaction mechanism of epitaxial growth that is premised on the parallel-plate single-wafer epitaxial apparatus widely used at present is illustrated in FIG. 5. The reaction gas is caused to flow in the reaction tube under a laminar flow condition, and a silicon source from a main gas flow is diffused through the boundary layer to be transported to a silicon (mirror surface) substrate of a wafer placed in a region in which the boundary layer has a constant thickness. The silicon source arriving at the silicon substrate surface is adsorbed, a growth point is reached through surface migration to cause a chemical reaction in which the adsorbed silicon source is incorporated into a crystal lattice, and epitaxial growth progresses at a constant rate. The silicon source diffused through the boundary layer to be transported to the silicon substrate surface at this point has a flow rate $F_1$ expressed by the following expression.

[Math. 1]

$$F_1 = h_G(C_G - C_S) = D(C_G - C_S)/\delta$$

In this expression, $h_G=D/\delta$ represents a transport coefficient, and $C_G$ and $C_S$ represent silicon source concentrations in the main gas flow (reaction gas) and on the substrate surface, respectively. The silicon source arriving at the substrate surface is adsorbed, and a crystal growth point is reached by surface migration to cause a chemical reaction in which the adsorbed silicon source is incorporated into the crystal lattice. An amount $F_2$ by which the silicon source is consumed by this chemical reaction (crystal growth) per unit time can be expressed by the following expression.

[Math. 2]

$$F_2 = Cs \cdot k_S = Cs \cdot k_0 \exp(-Ea/kT)$$

In this expression, $k_s=k_0(-Ea/kT)$ represents a surface reaction coefficient, Ea represents activation energy of the reaction, and "k" represents a Boltzmann constant. During epitaxial growth, $F_1=F_2$ is true, and a growth rate "v" can accordingly be expressed by the following expression.

[Math. 3]

$$v = \frac{F_1}{N} = \frac{F_2}{N} = \frac{1}{1/h_G + 1/k_s}\frac{C_G}{N}$$

In this expression, N represents an atomic density of single-crystal silicon.

In a case in which $h_G \gg k_S$ is true, $v \approx k_S \cdot C_G/N \approx C_G \cdot k_{0exp}(-Ea/kT)/N$ is established, and the rate of the epitaxial growth is consequently determined by the rate of the chemical reaction on the substrate surface. This is so-called reaction controlled epitaxial growth. In this case, the concentration $C_S$ of the silicon source on the substrate surface is close to the silicon source concentration $C_G$ of the main gas. In a case in which $k_S \gg h_G$ is true, $v \approx h_G \cdot C_G/N \approx (D/\delta) \cdot C_G/N$ is established, and the rate of the epitaxial growth is consequently determined by the thickness of the boundary layer and a rate at which the silicon source is diffused through the boundary layer. This is so-called diffusion controlled epitaxial growth. In this case, the concentration $C_S$ of the silicon source on the substrate surface is close to zero. Those two cases are extreme cases, and it is required to be understood that actual epitaxial growth is affected by both of $h_G$ and $k_S$ although at different ratios.

The foregoing description on the epitaxial growth mechanism is examination on how the growth rate varies, with transportation of the silicon source in a vertical direction to a flat surface in mind. Many patent applications related to epitaxial growth of a trench filling-type SJMOS have also proposed to prevent the blocking by employing reaction control in filling epitaxial growth. However, in epitaxial growth on a substrate having a non-flat surface shape such as a stepped shape or a trench shape, the growth rate cannot be discussed with the transportation of the silicon source limited to one direction. In epitaxial growth on a trench substrate, the growth rate is not always the same in all sites of trenches, and a control property of growth reaction cannot be determined in a uniform manner. An effective parameter for determining an optimum condition for trench filling epitaxial growth that is fast and free of void generation has been unclear, and has accordingly been searched for by trial and error (Patent Literature 5).

The film shape in deposition of a thin film on a substrate surface having a stepped shape or a trench shape has been discussed as a matter of step coverage with respect to various deposition methods. In a case of epitaxial growth of silicon as well, a transport phenomenon of the silicon source in a vapor phase and behavior of reactive species on the surface are required to be considered two-dimensionally and three-dimensionally, which complicates the discussion. In the following, quantitative consideration is aimed for by giving approximative consideration based on the reaction mechanism of epitaxial growth on a silicon substrate. In a case of using a parallel-plate single-silicon wafer epitaxial apparatus widely used for silicon substrates that are 200 mm or more in diameter, a thickness $\delta$ of the boundary layer illustrated in FIG. 5 is known to be from about 10 mm to about 15 mm through simulation. In contrast, a trench in an SJMOS of a 600 V class which is relatively high in withstand voltage is designed to have a depth of around 50 $\mu$m. With respect to transportation in a vertical direction in which the flow rate for transporting the silicon source in the vertical direction to the substrate surface through the boundary layer is $F_1$, or the transport coefficient $h_G$ (=$D/\delta$) in a trench bottom portion 7 is 0.99 or higher relative to the trench opening portion 8, transportation to the trench opening portion and transportation to the trench bottom portion can be approximated to be the same in the trench substrate as well as in the silicon substrate having a flat surface.

Growth reaction of epitaxial growth on the trench substrate progresses on the surface, the trench bottom surface and trench side walls. The temperature of the trench portion is constant and, accordingly, in a case in which the crystal plane orientation is the same, the surface reaction coefficient $k_S$ of the trench side walls is the same as $k_S$ of the silicon substrate surface. In epitaxial reaction on the trench substrate, transportation in a horizontal direction in relation to the surface is required to be considered as well. The trench substrate also has the same maximum molar quantity (when $C_S$=0 is true) of the silicon source supplied per unit time from a vertical direction through the boundary layer to a region of the silicon substrate prior to trench machining that has a surface area S. However, in the trench substrate, an area in which epitaxial growth occurs out of the region having the surface area S differs significantly. As illustrated in FIGS. 6, the reaction area on the trench substrate having the aspect ratio A is (A+ 1) times larger than on the silicon substrate in a case in which the oxide film 9 is removed.

The trench substrate can be approximated to the flat silicon substrate with regards to transportation in a vertical direction, and, at the same time, it is required to approximate an effective surface area of the trench substrate that relates to epitaxial growth to (A+1) times the effective surface area of the silicon substrate.

In a case in which the molar quantity of the silicon source supplied per unit time through the boundary layer is smaller than the molar quantity of the silicon source consumed by epitaxial growth in trench regions, that is, in a case in which $h_G<(A+1)k_S$ is true, $C_S$ on the substrate surface in which trenches are formed takes a value close to 0, and growth becomes diffusion controlled growth. In this situation, the silicon source transported through the boundary layer to the trench substrate surface reaches trench opening portion corners at an increased ratio. The silicon source from above the trench opening portion is consumed by epitaxial growth on the trench side walls and, accordingly, even $C_S$ that is not zero decreases toward the bottom portion. As a result, growth in the vicinity of the opening portion becomes fast enough to cause blocking. For prevention of such diffusion controlled reaction in a superficial layer of the trench substrate, $h_G>(A+1) k_S$ is required to be established. In order to satisfy this condition, it is required to set the maximum molar quantity of the silicon source supplied per unit time to the unit surface area S through the boundary layer to (A+1) times the molar quantity of the silicon source supplied to the silicon substrate in reaction controlled epitaxial growth or larger, or set the surface reaction coefficient $k_S$, that is, the growth rate, in the trench portion to 1/(A+1). Recognition of this point is not found in technological examinations that have been made about trench filling epitaxial growth.

A typical Arrhenius plot of epitaxial growth on a silicon (mirror surface) substrate with use of a parallel-plate single-wafer epitaxial apparatus widely used is shown in FIG. 7. The growth rate "v" can be approximated to $v \approx ks \cdot C_G/N$ and $v \approx h_G \cdot C_G/N$. A diffusion coefficient of the silicon source is in proportion to an absolute temperature to the power of three-halves, and accordingly a broken line $F_1$* indicates, in the form of the growth rate, a maximum amount $h_G \cdot C_G$ of the silicon source supplied to the substrate at each temperature, with respect to two examples of gas conditions for fast growth reaction. In order to fill a trench having an aspect ratio of 10 which has been put into practical use by the reaction controlled epitaxial growth which satisfies $h_G \cdot C_G>(A+1) k_S \cdot C_G$, when the growth temperature is lowered to 900°C, even a reaction gas condition of 4.0 μm/min at 1,150°C is insufficient, and a reaction gas condition of about 6.0 μm/min is required. This growth rate is achievable only by a limited number of epitaxial apparatus. Even when the growth temperature is lowered to 900°C or less to decrease the growth rate and the condition is satisfied, an epitaxial layer of good quality cannot be obtained at that temperature.

As a way to slow down epitaxial growth reaction other than lowering of the growth temperature, there is a method that adds hydrogen chloride gas, which is a product gas of epitaxial reaction, to the reaction gas. Selective epitaxial growth using an oxide film as a mask has been practiced for some time. In particular, nucleus growth hardly occurs on an oxide film, and it can accordingly be arranged so that epitaxial growth progresses only in an exposed portion of a silicon crystal. Epitaxial reaction using trichlorosilane as a raw material is expressed by the following formula.

[Chem. 1] $SiHCl_3 + H_2 \rightarrow Si(s) + 3HCl$

This reaction is an equilibrium reaction in which a reverse reaction occurs as well, and is a non-equilibrium stationary reaction in which epitaxial growth progresses with a supply of $SiHCl_3$ in a constant concentration to a reaction region (in proximity of the substrate surface), hydrogen chloride (HCl) gas which is a product gas is simultaneously discharged from that region, and the reaction progresses at a constant rate. When HCl gas is added to the reaction gas, a rate at which HCl of the product gas is diffused through the boundary layer to be discharged out of a reaction furnace decreases, and the resultant high concentration of HCL gas on the substrate surface on which epitaxial reaction occurs slows down the epitaxial reaction because a rate $k_{-1}$ of reverse reaction increases in proportion to $[HCl]^3$ (Le Chatelier's principle). The growth rate can be decreased by one or more digits by adding HCL at a constant temperature without changing a supply condition of $SiHCl_3$.

An example of a relationship between the growth rate and an added amount when the reaction gas added with hydrogen chloride gas is used in epitaxial growth on the silicon (mirror surface) substrate is shown in FIG. 8. When HCl gas is added at a flow rate that is approximately the same as the flow rate of $SiHCl_3$, the growth rate drops to one tenth or less. In the case of FIG. 8 in which a parallel-plate epitaxial apparatus is used, the flow rate of the reaction gas is set to from about 70 L to about 75 L, and accordingly an increase in total flow rate of the reaction gas and a decrease in concentration $C_G$ of $SiHCl_3$ when HCl gas is added are each 5% or less. It is understood that, by adding hydrogen chloride, the silicon source supply amount and the growth rate can be controlled independently of each other in epitaxial growth without changing the growth temperature.

In a textbook on step coverage of CVD, a condition of CVD and the shape of a deposited film are summarized as in FIGS. 10. It is understood that surface migration is important in obtaining a film shape that is conformal. A situation in which surface migration hardly occurs in epitaxial growth of silicon is diffusion controlled reaction (FIG. 10(C)) in which, when the silicon source reaches the substrate at a high temperature, $k_S \gg h_G$ and $C_S \approx 0$ are established to cause immediate reaction before surface migration occurs, and silicon atoms are consequently incorporated into the crystal lattice, or a state in which surface migration hardly occurs due to low temperature. In a case in which the naturally oxidized film has been removed, when the temperature rises from 900°C in a hydrogen atmosphere, surface migration of silicon atoms gradually becomes active, a resultant drop in surface roughness, that is, a drop in surface area, causes start of a drop in surface energy, and, at 1,100°C, a phenomenon (silicon-on-nothing) in which a curvature of the trench opening portion drops to cause blocking in 1 minute to 2 minutes is known to be observed. It is considered that conformal deposition as in FIG. 10(A) is achieved by the reaction controlled growth in a temperature range of from 900°C to 1,100°C.

From the examination given above, it is concluded that, at a high temperature T1°C which is around 1,150°C and at which diffusion controlled growth takes place, when the rate of epitaxial growth on a silicon (mirror surface) substrate under a certain reaction gas condition is X μm/min (a first preparation step of claim 2), and the growth temperature is lowered to T2°C which is around 1,000°C to perform selective epitaxial growth without changing the reaction gas condition, an amount by which a silicon source is supplied to the substrate surface is $[(T1+273)/(T2+273)]^{-3/2}X$ μm/min. To add hydrogen chloride gas to the reaction gas of the certain reaction gas condition for selective epitaxial growth on the silicon substrate, a flow rate at which the growth rate is lower than $[(T1+273)/(T2+273)]^{-3/2}X/(A+1)$ μm/min is calculated. It is understood that, by adding hydrogen chloride (according to a second preparation step of claim 2) to the reaction gas at the calculated flow rate and performing selective epitaxial growth on a trench substrate that has the aspect ratio A, the supply amount of the silicon source is ensured to exceed the consumed amount in selective epitaxial growth on the substrate in which trenches are formed. The growth temperature in the selective epitaxial growth is required to be between 900°C and 1,100°C, and is desirably within a range of from 950°C to 1,050°C.

In a case in which a trench is filled by selective epitaxial growth with hydrogen chloride gas added to a reaction gas that is a mixture of trichlorosilane and hydrogen gas, it is confirmed from, among others, a result of observing the trench in the middle of the growth by cross-sectional SEM that a local growth rate of a trench portion is slower than in epitaxial growth on the silicon substrate. The amount of the silicon source consumed by epitaxial growth in the trench portion per substrate surface area is large in correspondence to the aspect ratio, and a generation amount of HCl gas which is a reaction product per substrate surface area is accordingly large as well. The HCl gas is diffused through the boundary layer, flows into the main gas flow, and is discharged from the reaction chamber, and the HCl gas concentration on the boundary layer substrate side on which the epitaxial growth is performed is accordingly higher than in the case of the silicon substrate. It has empirically been known that, in a trench substrate that has a trench depth of from 40 μm to 50 μm, a pn column pitch of 10 μm or less and an aspect ratio of from 10 to 20, void generation does not occur when an amount by which HCl is added to the reaction gas is determined so that the growth rate is $1.2X/(A+1)$ μm /min or less in the second preparation step of claim 2 (See FIG. 14). In a case of manufacturing a PMOS that has a trench width of 1 μm or less, a trench depth of 10 μm or less, and a low withstand voltage around 100 V, from a trench filling-type SJMOS, and in a case of manufacturing an SJMOS that has a trench depth of from 80 μm to 100 μm and a withstand voltage of around 1,000 V, for example, the HCl gas concentration on the boundary layer substrate side cannot be obtained by calculation, and it is accordingly required to determine an optimum addition amount of HCl by an empirical method.

In development of a manufacturing technology of a trench filling-type SJMOS that has been made thus far, a procedure in which halide gas is added to the reaction gas under a diffusion controlling condition, and, in parallel with epitaxial growth, etching and growth are inhibited in the proximity of the opening portion to set the growth rate low in the opening portion than in the trench bottom portion and thus prevent blocking has been proposed, and specific measures have been examined. However, whether that has been achieved has not clearly been confirmed, due to difficulties of measuring the growth rate. In a case in which hydrogen chloride gas is added and dichlorosilane or trichlorosilane is used as a source, HCl gas which is a product permeates interior of the trench, and is diffused from the opening portion through the boundary layer to be discharged from the reaction furnace as shown in FIGS. 10, and it is accordingly considered to be unfeasible in principle to lower the growth rate near the trench opening portion than the growth rate in the bottom portion.

In the selective epitaxial growth performed on the substrate in which trenches are formed to fill the trench, the flow rate at which HCl gas is added to the reaction gas is determined so that the growth rate on the silicon substrate is $[(T1+273)/(T2+273)]^{-3/2}X/(A+1)$ μm/min or less. However, the inventor of the present invention has empirically found out that, because an increase in effective reaction area of the trench substrate causes the hydrogen chloride gas concentration of the reaction region to become higher than in the case of the silicon mirror surface substrate, it is sufficient, in most cases, to add HCl gas at a flow rate that sets the growth rate to $1.2X/(A+1)$ μm/min or less. In addition, a premise of the foregoing description is that trenches are formed on the entire surface of the trench substrate, and a slight adjustment may be required to deal with a situation of the mask pattern or the like in a case in which the oxide film used as a mask when the trenches are etched by RIE is chosen to be left, and a case in which there are portions with no trenches formed therein, such as element periphery portions and scribe lines.

Trench filling epitaxial growth is a process in which trenches are formed in a single crystal by machining and are filled by epitaxial growth, and an overview of the importance of choosing a crystal plane advantageous to that process is given in [0019]. The biggest challenge is to fill trenches by fast epitaxial growth in a manner that avoids generation of a void. Major crystal planes are sorted by epitaxial growth rate as follows: (110)>(100)>(111). When a rate at which a silicon source is supplied to a growth surface is the same, a plane high in growth rate is low in silicon source concentration. When surfaces of different crystal planes are adjacent to each other, as illustrated in FIG. 11, the silicon source is diffused by surface migration from the surface having a high silicon source concentration to the surface having a low silicon source concentration to be taken into the crystal, and the growth rate in that portion accordingly increases. In a structure having a surface that is a (100) plane and a side surface that is a (110) plane, a (111) plane is generated in a joint portion, and the silicon source migrates from there by surface migration in a large quantity to the (110) side on which the surface concentration is low, to thereby generate a portion in which the growth rate is high in an upper part of the trench side wall, and thus cause void generation. In a case in which the surface and the side wall are each a (100) plane, a (110) plane is generated in the joint portion, a portion in which the growth rate is high is not generated in an upper part of the side wall that is a (100) plane, and, accordingly, blocking is not accelerated in the trench opening portion. This is true also when there is an oxide film. When surface migration occurs in a somewhat large scale during filling epitaxial growth, the growth progresses so that a (110) plane which is stable in terms of energy is formed in the trench opening portion, and so that the surface area becomes small in corner portions of the trench bottom portion, a (310) plane is formed to create a shape that hinders generation of a void, and filling of the trench progresses.

According to the present method, the Bosch process which is employed for forming of a through-electrode and which enables high-speed etching of a trench is usable as a measure to form a deep trench in a substrate by reactive ion etching. Not only scallops which are minute concavities and convexities unique to the Bosch process but also the trench is filled in a manner that decreases the surface area, because the scale of surface migration is ensured to be appropriate without extremely strict machining of an angle of the side surfaces of the trench, and, accordingly, surface energy drops and stabilizes. When blocking due to a drop in curvature in the trench opening portion is avoided, no voids are generated and filling progresses so that the interior of the trench decreases in surface area and is eventually planarized.

FIGS. 12 are cross-sectional schematic views for illustrating an initial stage, an intermediate stage and a completed state of the trench filling step and a cross-sectional SEM photograph for showing the intermediate stage when a trench is being filled under an epitaxial growth condition of 1,000°C at which the scale of surface migration is large. It is observed by cross-sectional SEM that filling starts from corners of the bottom portion so that the surface energy drops. In the case in which both of the surface and the trench side walls are (100) planes, a (310) plane low in surface energy is formed in the trench bottom portion, and a (110) plane is formed in the trench opening portion. The reaction area of the trench portion gradually decreases and, accordingly, the amount by which the silicon source is consumed in the trench portion can be prevented from exceeding the amount of the silicon source supplied to the trench portion through the boundary layer even when the growth rate is set high. In light of this, the hydrogen chloride gas concentration is lowered under an appropriate condition and the temperature is raised, to thereby achieve filling free of void generation in a short time at an increased growth rate suitable for the filling state of the trench portion. In this manner, manufacturing of an SJMOS at low cost and productivity superior to the productivity of the multi-epitaxial growth method is achieved.

When trench filling epitaxial growth is performed under the thus obtained selective epitaxial growth conditions at a temperature close to 1,000°C, the interior of the trench is gradually filled with an epitaxial layer and, ultimately, the entire trench is filled with the epitaxial layer 13. When over-deposition in which the epitaxial growth is continued further after the trench portion is filled with the epitaxial layer on the entire substrate surface is executed, the epitaxial layer spreads from the upper part of the trench onto the oxide film as illustrated in Step (d) of FIG. 3. In a case in which there is no oxide film, the surface becomes flat so that the surface energy decreases by surface migration. An appropriate end point of the filling epitaxial growth is determined by the trench shape and in-plane fluctuations of the growth rate, and is accordingly determined, at first, through observation of appearance.

Next, an over-deposition layer formed above the opening portion of each trench 20 is removed by mechanochemical polishing that uses colloidal silica. At this point, the oxide film above the trench acts as a stopper of polishing, and silicon above the oxide film is removed by polishing. This stage is as illustrated in Step (e) of FIG. 3. Based on an alignment mark at this stage, a new alignment mark usable in Step (f) of FIG. 3 can be formed. The oxide film is removed by wet etching, and level differences of from 1 μm to 2 μm of silicon are removed by polishing, to thereby obtain a substrate having a flat surface such as the one illustrated in Step (f) of FIG. 3. In the case in which the oxide film has completely been removed prior to the trench filling epitaxial growth, over-deposition that is approximately as wide as the trench width is sufficient to obtain a flat surface. In subsequent steps, a p-well is formed above a p-type trench by devising a suitable way with respect to alignment, and the rest of the manufacturing process of the SJMOS can be executed in accordance with a normal manufacturing process of a PMOS.

[Example 1]

A more specific description of the present invention is given below through Example of the present invention, but the present invention is not limited thereto. The present invention is applicable to a deep trench that is approximately 100 μm and a minute trench as shallow as 10 μm or less both by lowering the growth pressure.

On the $n^+$-type, single-crystal, silicon substrate 11 having a diameter of 200 mm and a crystal orientation of (100), the epitaxial layer 12 having a resistivity of around 1 Ω cm and a thickness of 55 μm was grown by the epitaxial growth method to prepare the $n/n^+$-type silicon epitaxial substrate 1. This substrate 1 is (100) in surface orientation and notch orientation. Next, an oxide film was formed on a surface of the substrate 1, an oxide film mask pattern was formed by photolithography, and then the trenches 20 in each of which each of a side wall and a bottom surface has a crystal orientation of (100) were formed by RIE (the Bosch process) so as to have a depth of 50 μm. Line widths of the trenches are 3.0 μm, 4.5 μm and 6.0 μm (pitch widths are 6 μm, 9 μm and 12 μm, respectively). After etching was finished, damage was removed by polymer washing and SC1 washing, and the process was advanced to the next step with the mask oxide film left as it was.

In the present method, in a step of filling the trenches 20 by epitaxial growth, two preparation steps are executed first through epitaxial growth on a low-resistance silicon (mirror surface) substrate. An epitaxial growth rate at a high temperature which is a diffusion controlling condition is a supply amount of a silicon source supplied to the silicon substrate per unit time. A first step is executed to figure out a reaction gas condition under which the supply amount is large, and a specific value of the supply amount. A second step is executed to obtain, by calculation, from the actual measurement value obtained in the first step, a supply amount of the silicon source supplied to a substrate unit surface under the growth gas condition described above, when the growth temperature is lowered to a temperature favorable for trench filling epitaxial growth, and to obtain, from epitaxial growth on the silicon substrate, a flow rate at which hydrogen chloride gas is added to the reaction gas in trench filling performed on a trench substrate that has the aspect ratio A by selective epitaxial growth at the favorable temperature, in order to lower the growth rate to a rate at which an amount of the silicon source supplied per unit time to the substrate unit surface is not exceeded by an amount of the silicon source consumed per unit time by selective epitaxial growth in that region. The trenches 20 are filled by selective epitaxial growth under growth conditions that use the growth gas condition and the hydrogen chloride gas addition flow rate obtained in those two steps (see FIG. 9).

The first preparation step was carried out with use of an epitaxial reactor (Centura) that was a product of Applied Materials, Inc. and that was similar to the apparatus of FIG. 4. An epitaxial growth gas condition that set an epitaxial growth rate X μm/min to 5.0 μm/min or higher in growth on an $n^+$-(100) mirror surface wafer at 1,150°C was obtained. It is common to avoid use of such a condition in mass production because fast growth at as high a growth rate as 5.0 μm/min or higher causes a problem of adhesion of polysilicon to a reaction tube. However, the problem of adhesion of a reaction product to the reaction tube is small in trench filling epitaxial growth which is performed at 1,000°C. For the silicon source, trichlorosilane advantageous to supply of a source at a high concentration was used. A mixture gas containing trichlorosilane in a concentration of 20% in hydrogen gas was prepared by bubbling of hydrogen gas in liquid trichlorosilane ($SiHCl_3$), and was used as a silicon source gas. A carrier hydrogen gas was set to 50 slm, the silicon source gas described above was mixed with the carrier hydrogen gas, and a flow rate of 5 Mslm of the silicon source gas was obtained as a flow rate at which the growth rate X μm/min was 5.0 μm/min. A slightly reduced pressure of 750 torr was used as a growth pressure condition. A minute amount of diborane diluted with hydrogen gas was also added to the supply gas so that the resistivity of the epitaxial layer was around 1 Ω cm. The flow rate of that mixture gas was adjusted with use of a mass flow controller. It was confirmed that the epitaxial layer had an in-plane film thickness distribution of ±2.5% or less and an in-plane resistivity distribution of ±3.5% or less. The fast growth condition increases the flow rate at which the silicon source is supplied to the substrate surface, and thus enables fast reaction controlled filling growth.

Next, the second preparation step was carried out. A new $n^+$-(100) silicon substrate was loaded into the epitaxial apparatus, the temperature was raised to 1,100°C to perform pre-annealing in a hydrogen atmosphere for 3 minutes, the temperature was then lowered to 1,000°C for growth performed without changing the reaction gas flow rate condition from the condition in the above-mentioned epitaxial growth at 1,150°C (the carrier hydrogen gas: 50 slm, the silicon source gas containing 20% of trichlorosilane in hydrogen gas: 5 Mslm), with hydrogen chloride gas added thereto, and hydrogen chloride gas flow rates Hslm corresponding to respective growth rates on the silicon substrate were obtained as flow rates at which the growth rates on the silicon substrate were 0.15 μm/min, 0.30 μm/min, 0.45 μm/min and 0.60 μm/min.

Three types of trench forming substrates which were 3.0 μm, 4.5 μm and 6.0 μm in trench opening width were prepared, and the epitaxial growth conditions obtained in the first and second preparation steps were used to fill trenches with selective epitaxial growth under reaction gas conditions including addition of hydrogen chloride gas at the flow rates Hslm obtained in the preceding step as flow rates at which the growth rates on the silicon substrate were 0.15 μm/min, 0.30 μm/min, 0.45 μm/min and 0.60 μm/min. The selective epitaxial growth was performed on four trench forming substrates for each condition. In the selective epitaxial growth, a predetermined amount of diborane was added, to thereby give a p-type conductivity and a resistivity of about 1 Ω cm to a filling epitaxial region so that, in later observation with an electron scanning microscope, by performing defect etching in a small etching amount, a positional relationship of a defect to a boundary between p-type and n-type regions was able to be known. Strict control of the resistivity of the epitaxial layer was not executed. In order to check a state in the middle of the filling epitaxial growth, an auxiliary substrate which had a trench opening width of 4.5 μm and in which the filling epitaxial growth was aborted halfway through was prepared.

In the epitaxial growth step, after the trench substrate was placed on the susceptor 23 and the temperature of the wafer was raised to 1,100°C for a short time in a hydrogen atmosphere to remove the naturally oxidized film, the temperature was lowered to 1,000°C, and each gas was supplied under the already obtained conditions without changing the conditions during epitaxial growth to fill the trenches by selective epitaxial growth. The growth time varies depending on the trench opening width and the aspect ratio. Accordingly, the end point of the filling epitaxial growth was determined for each condition at an appropriate point in time by observing fluctuations in an outer peripheral portion and a central portion of the wafer at the time when the epitaxial film started to grow on the oxide film. The wafer was then cooled down and taken out. The filling epitaxial growth required a growth time that is 1.5 to 3 times longer than a length of time expected from the trench width when the rate of growth on the side walls is assumed to be the rate of growth on the silicon substrate.

Three wafers on which the trenches of the substrates varied in trench shape had been filled by epitaxial growth in the preceding step were prepared for each condition, and were each diced and cleaved into chips at R/2 along a straight line that runs through the center of the wafer and at 10 mm from the outer circumference, namely, at five points in total. After defect etching was performed on the chips so that positions of the trenches were known, a scanning electron microscope was used to observe a situation of void generation. In SEM, the number of trenches that can be observed varies depending on the pitch of the trenches, and a chip in which no voids were observed in all trenches within a viewing field was deemed to be a nondefective product. Results thereof are shown in FIG. 14. A symbol "○" indicates that no void generation was observed at all points out of the five measurement points of each wafer, a symbol "△" indicates that voids were found at some of the measurement points, and a symbol "×" indicates that voids were found at most of the measurement points. A numerator of a parenthesized fraction indicates the number of points at which no voids were found out of the five points. In chips ranked as "△", most voids were generated outside the point 10 mm from the outer circumference. For reference, values of a growth rate expressed by 1.2X/(A+0.5), in this case, a growth rate calculated by division of 6 μm/min by a value that is the aspect ratio plus 0.5, are shown in the graph by the broken line. Results of observing the substrate on which the trench opening width was 4.5 μm and the growth had been aborted halfway through by SEM observation after the substrate was cleaved are shown in FIGS. 13.

It has been confirmed from those results that, when hydrogen chloride gas is added at 1,150°C under a gas condition that sets the growth rate as high as 5.0 μm/min, and the growth rate at 1,000°C is set to the aspect ratio A of the trenches, filling by epitaxial growth free of void generation is successfully achieved by filling the trenches under an epitaxial growth condition that sets the growth rate to 1.2X/(A+0.5) or less. It has also been confirmed that substantially no voids were actually generated when trenches having a trench width of 3 μm and a depth of 50 μm are filled under an epitaxial growth condition that sets the growth rate on a silicon substrate to 0.30 μm/min at which no voids have been speculated to be generated. The growth time including over-deposition was from 20 minutes to 30 minutes. This growth time is considered to be equal to or less than 1/4 to 1/2 of any of the few trench filling epitaxial growth times that have been reported in patent publications.

As for the remaining one wafer, a colloidal silica-based polishing agent was used to remove the over-deposition layer by polishing, the oxide film was subsequently removed by wet etching, and then the wafer was re-polished to reach a mirror surface state. Defect etching was performed and crystallinity on the surface of the substrate was examined with an optical microscope. No voids were observed and, although slight slip dislocation due to the oxide film was observed in places, the wafer was confirmed to have the same level of stacking fault density as that of a normal epitaxial wafer.

[Reference Signs List]

1 epitaxial substrate, 2 trench substrate, 7 trench bottom portion, 8 trench opening portion, 9 mask oxide film, 11 $n^+$-type silicon substrate, 12 n-type epitaxial layer, 13 p-type filling epitaxial layer, 14 p-well, 15 source, 16 gate electrode, 17 gate insulating film, 18 source electrode, 19 drain electrode, 20 trench, 21 halogen lamp, 22 top board, 23 susceptor, 24 gas inlet, 25 lift pin, 29 gas outlet, 31 silicon substrate, 32 boundary layer, 33 radiation thermometer.

## Claims

1. A method of manufacturing a semiconductor element having a super junction structure which uses a selective epitaxial growth method by a single-wafer reactor in manufacture of the super junction structure in which trenches formed in a stripe pattern in a silicon substrate are filled with an epitaxial layer having a conductivity type different from a conductivity type of the silicon substrate, the method comprising:

   a first preparation step including: setting a condition under which epitaxial growth on a low-resistance silicon substrate (1) having the same crystal orientation as a crystal orientation of the silicon substrate in which the trenches are formed is stable, fast and diffusion controlled growth; obtaining, from flow rate conditions of a silicon source gas and a carrier hydrogen gas of a reaction gas in the set condition and a growth rate at a temperature of the set condition, a molar quantity of a silicon source supplied per unit time to a unit surface of the silicon substrate; and further obtaining, through calculation, a supply amount of the silicon source at each temperature when a growth temperature alone is changed;
   a second preparation step including: lowering, without changing the flow rate conditions of the reaction gas, a temperature of selective epitaxial growth for filling the trenches which are formed in the silicon substrate and which have an aspect ratio A to 1,000±50°C, which is a favorable temperature; obtaining, through calculation, an epitaxial growth rate at which a molar quantity of the source consumed per unit time by epitaxial growth for filling the trenches that have the aspect ratio A in a region of the unit surface at the favorable temperature is prevented from exceeding the molar quantity obtained in the first preparation step as the molar quantity of the source supplied to the unit surface of the silicon substrate per unit time; and figuring out a flow rate at which hydrogen chloride gas is added to the reaction gas in a manner that sets a rate of selective epitaxial growth performed at the favorable temperature of growth, with the hydrogen chloride gas added under the condition of the reaction gas, on a low-resistance silicon substrate (2) having the same crystal orientation as the crystal orientation of the silicon substrate in which the trenches are formed, to the epitaxial growth rate obtained through the calculation; and filling the trenches formed in the silicon substrate by a selective epitaxial growth method that uses the condition of the reaction gas and the favorable temperature of growth that are set in the first preparation step and the second preparation step and a condition of the hydrogen chloride gas addition flow rate figured out in the second preparation step, to thereby perform reaction controlled epitaxial growth in which an amount of the silicon source consumed on the unit surface of a trench portion is exceeded by the supply amount of the source, and thus fill the trenches at a fast growth rate within a range in which no voids are generated.

**2.** The method of manufacturing a semiconductor element having a super junction structure according to claim 1,

wherein the first preparation step includes setting a reaction gas flow rate condition G1 about a flow rate of the silicon source gas and a flow rate of the hydrogen carrier gas so that a growth rate X μm/min is 3.0 μm/min or more and 5.0 μm/min or less at a growth temperature T1°C within a range of from 1,100°C to 1,150°C in which epitaxial growth on the low-resistance silicon substrate (1) having the same crystal orientation as the crystal orientation of the silicon substrate is a diffusion controlled reaction, and the second preparation step includes setting an epitaxial growth temperature T2°C for filling the trenches having the aspect ratio A without changing the reaction gas flow rate condition G1 within a range of 1,000±50°C, and obtaining the hydrogen chloride gas addition flow rate as a flow rate that sets a growth rate to $[(T1+273)/(T2+273)]^{-3/2}X/(A+1)$ μm/min or less in selective epitaxial growth performed on the low-resistance silicon substrate (2) having the same crystal plane as a crystal plane of the silicon substrate in which the trenches are formed, by adding hydrogen chloride gas to the reaction gas, and wherein the trenches formed in the silicon substrate are filled by selective epitaxial growth that uses the flow rate conditions of the reaction gas, the growth temperature and the hydrogen chloride gas addition flow rate that are set in the first preparation step and the second preparation step, to thereby perform reaction controlled epitaxial growth in which the supply amount of the silicon source exceeds an amount of the silicon source consumed in all sites of each of the trenches, and thus fill the trenches by a selective epitaxial growth process free of void generation.

**3.** The method of manufacturing a semiconductor element having a super junction structure according to claim 2, wherein, when the trenches formed in the stripe pattern in the silicon substrate to be filled by selective epitaxial growth have a pitch of 10.0 μm or less and an aspect ratio of 10 or more, a flow rate that sets the growth rate to 1.2X/(A+1) μm/min or less in selective epitaxial growth on the low-resistance silicon substrate (2) having the same crystal plane as the crystal plane of the silicon substrate in which the trenches are formed is obtained as a flow rate at which hydrogen chloride gas is added to the reaction gas in the selective epitaxial growth for filling the trenches, and the trenches formed in the silicon substrate are filled by the selective epitaxial growth performed at the obtained flow rate of addition.

**4.** The method of manufacturing a semiconductor element having a super junction structure according to claim 1, wherein the method uses the silicon substrate in which the trenches are formed by machining so that a surface of the silicon substrate and side walls of the trenches in a longitudinal direction are a (100) plane and (100) planes, respectively, or so that the surface of the silicon substrate and the side walls of the trenches are a (110) plane and (111) planes, respectively, out of combinations of crystal planes that set an epitaxial growth rate on the surface of the silicon substrate in which the trenches are formed to a rate higher than or equal to an epitaxial growth rate on crystal planes of the side walls of the trenches.

**5.** The method of manufacturing a semiconductor element having a super junction structure according to claim 1, wherein, in reactive ion etching for forming the trenches, a Bosch process used in deep-trench etching for a through-electrode having excellent productivity is used, minute concavities and convexities which are caused in an etched surface by the Bosch process and which are called scallops are smoothed out by setting a temperature condition of the selective epitaxial growth to 1,000±50°C, satisfying a reaction controlling condition by way of a flow rate at which hydrogen chloride gas is added, and smoothing a growth surface at an early stage of growth under an epitaxial condition that renders a scale of surface migration of the silicon source large, and the trenches are thus filled with an epitaxial layer of an excellent crystal quality free of micro-voids and misfit dislocation.

**6.** The method of manufacturing a semiconductor element having a super junction structure according to claim 1, wherein, with progress of filling of the trenches by epitaxial growth, a growth area of the trench portion decreases to diminish a consumption amount of the silicon source per unit time, and productivity is accordingly improved by reducing an amount by which hydrogen chloride gas is added, in a manner corresponding to a change in the consumption amount within a range in which a reaction controlling condition is maintained, or by raising the growth temperature to increase a filling epitaxial growth rate and thus shorten a growth time.

Fig.1

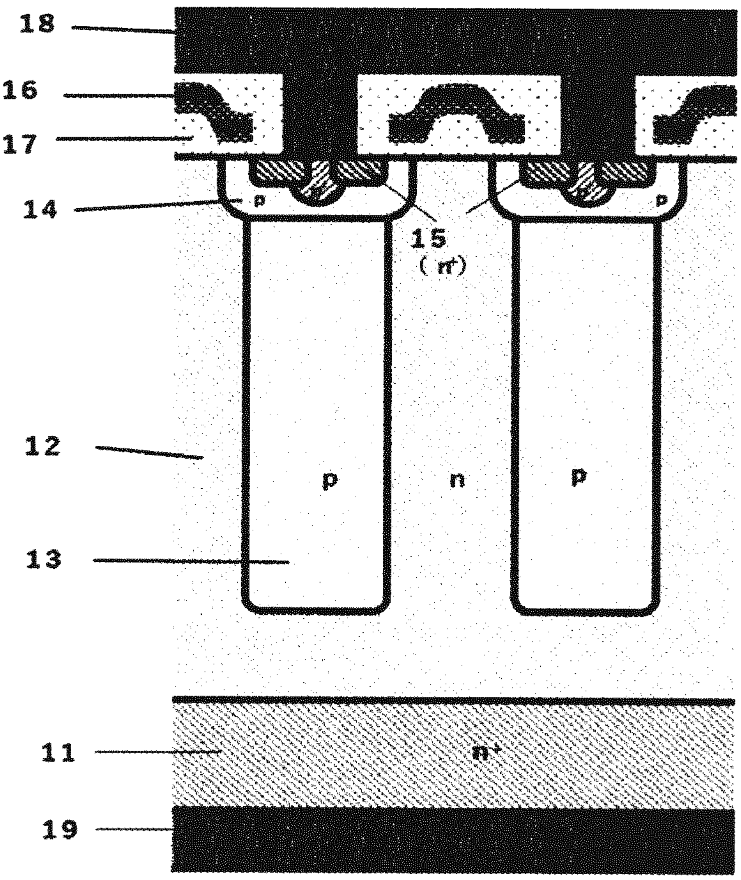

Fig.2

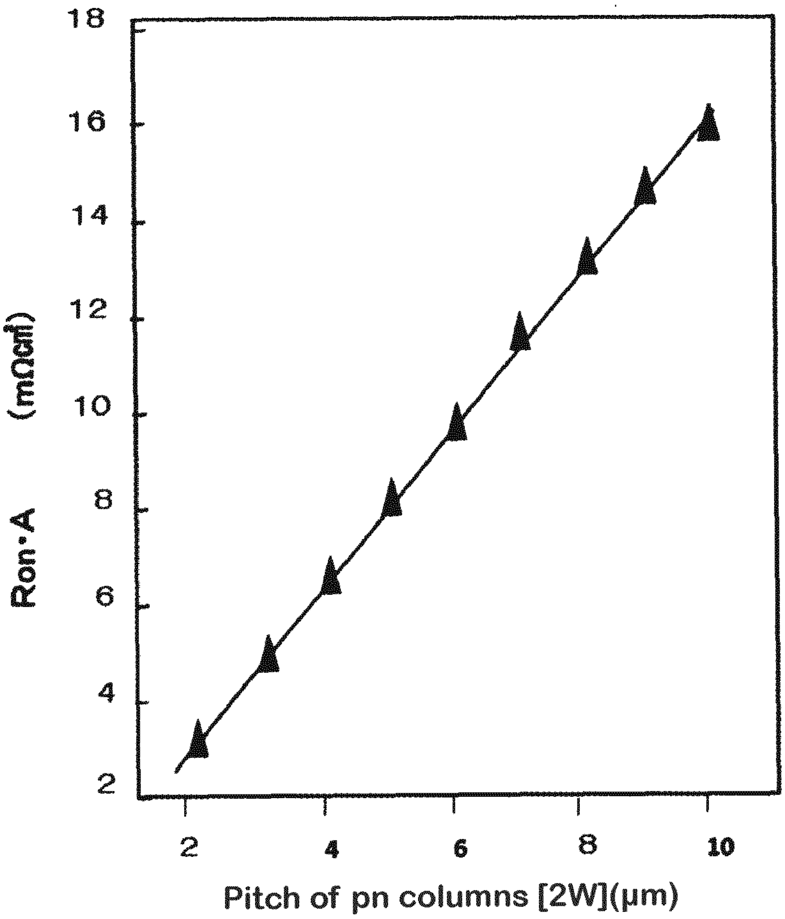

# Fig.3

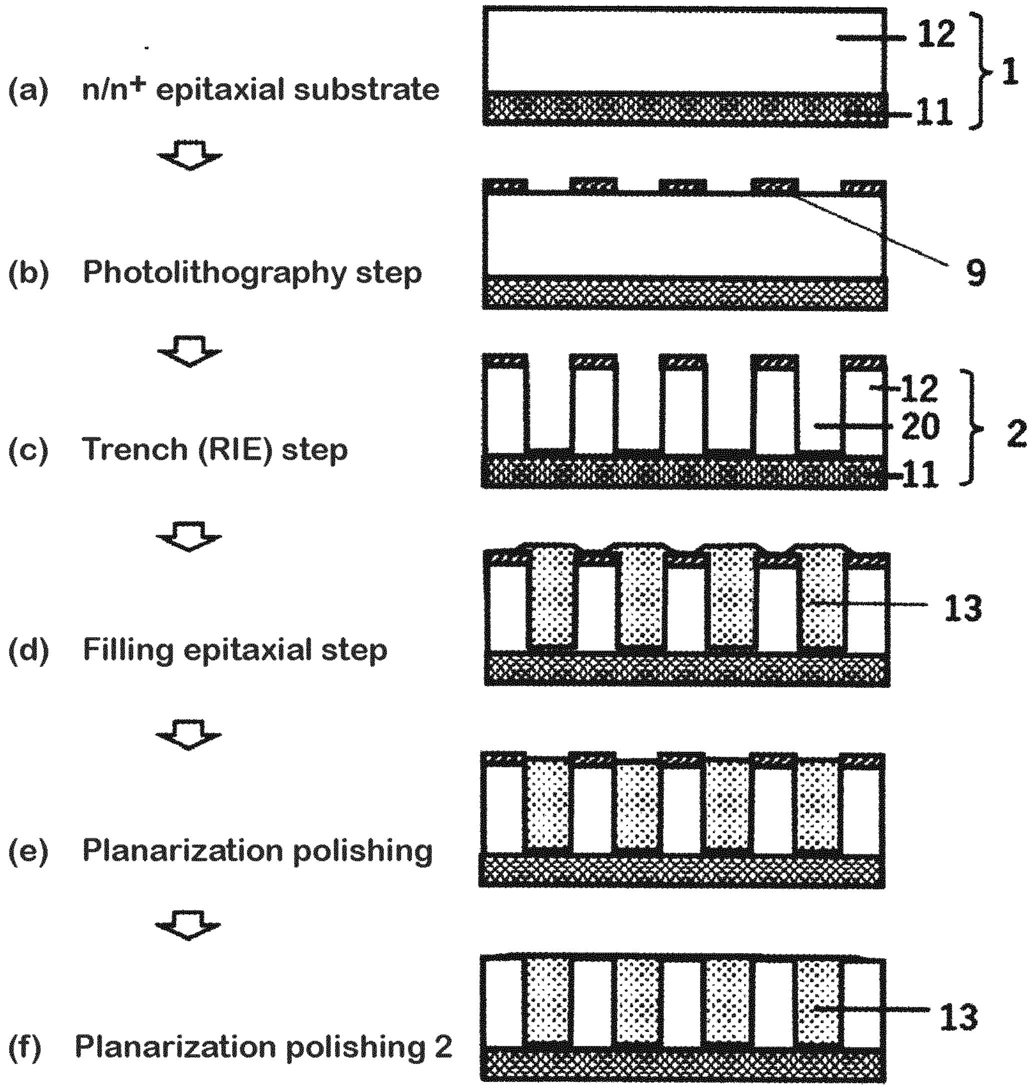
(a) n/n+ epitaxial substrate
12
1
11
(b) Photolithography step
9
(c) Trench (RIE) step
12
20
2
11
(d) Filling epitaxial step
13
(e) Planarization polishing
(f) Planarization polishing 2
13

# Fig.4

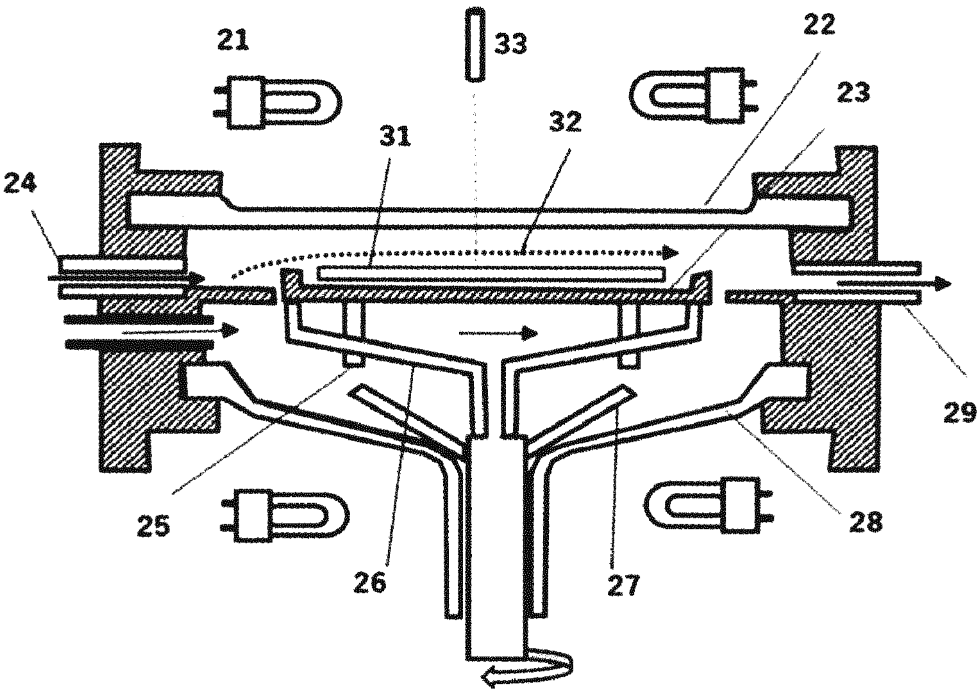
21
33
22
23
31
32
24
29
25
26
27
28

# Fig.5

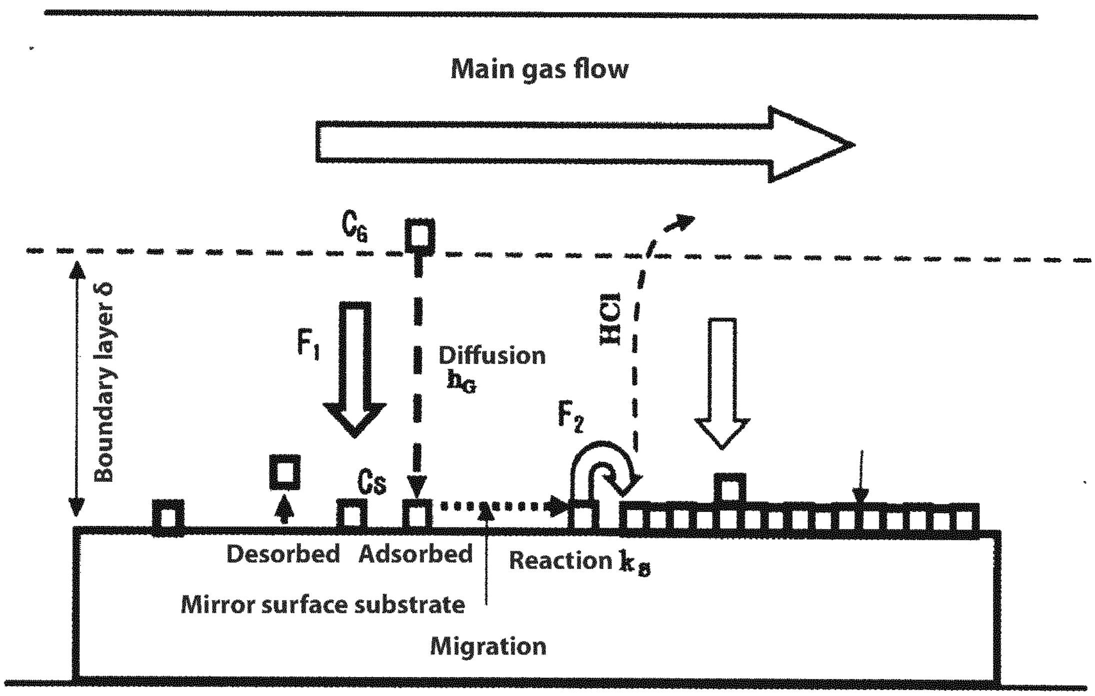
Main gas flow
$C_G$
Boundary layer δ
$F_1$
Diffusion
$h_G$
HCl
$F_2$
Cs
Desorbed
Adsorbed
Reaction $k_S$
Mirror surface substrate
Migration

# Fig.6

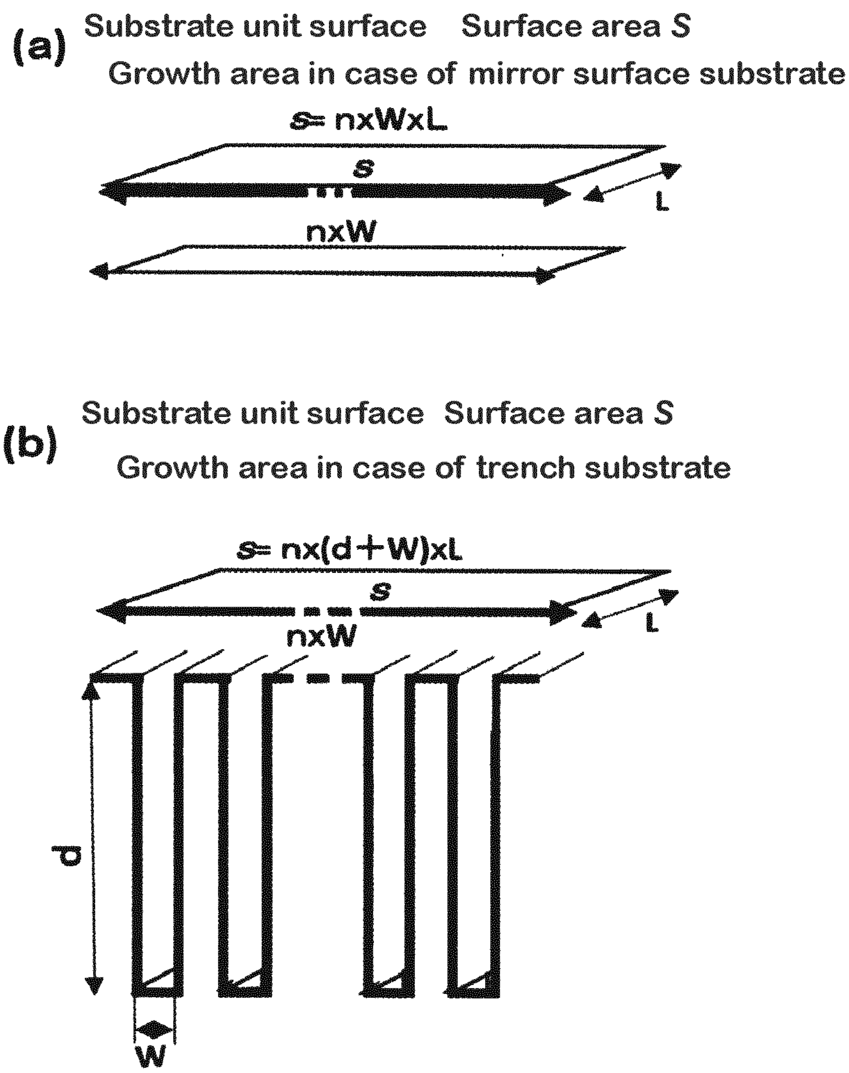
(a)
Substrate unit surface
Surface area S
Growth area in case of mirror surface substrate
s= nxWxL
s
L
nxW
(b)
Substrate unit surface
Surface area S
Growth area in case of trench substrate
s= nx(d+W)xL
s
nxW
L
d
W

Fig.7

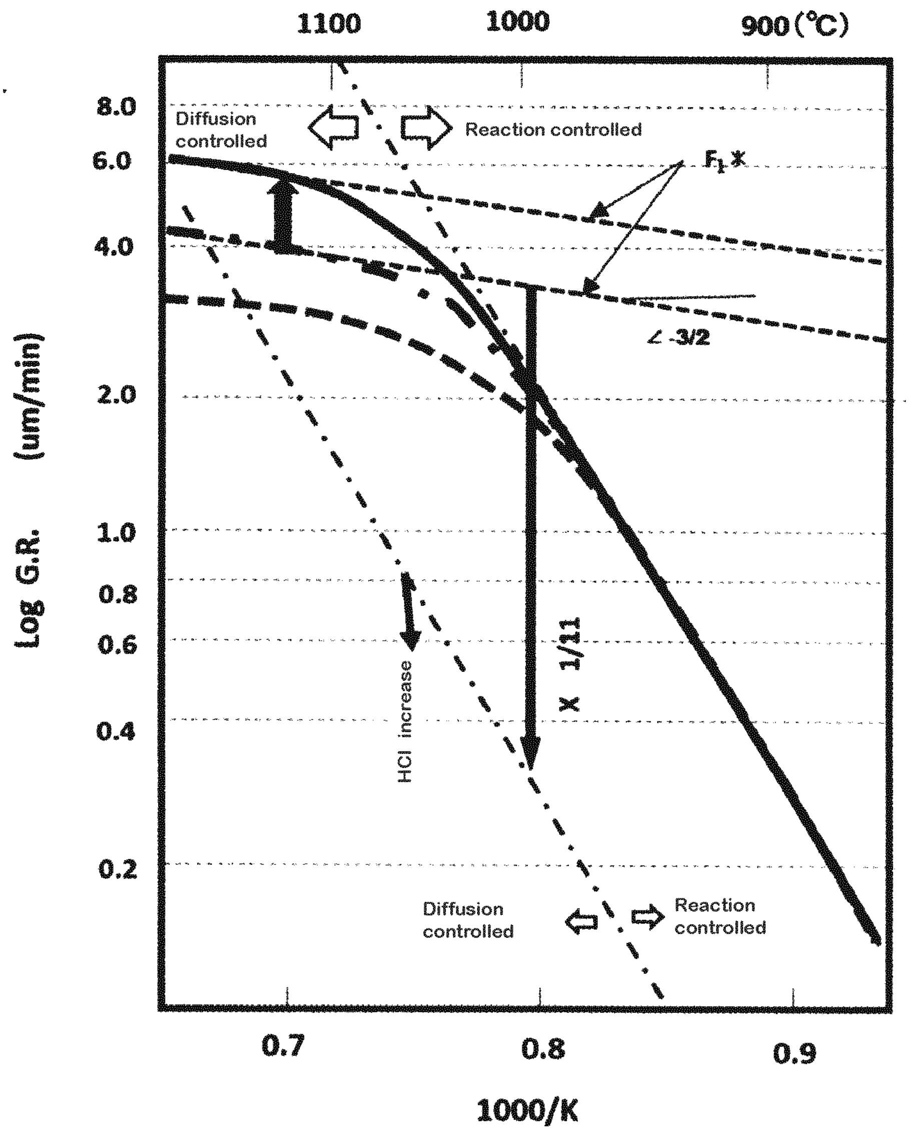
1100
1000
900 (°C)
8.0
6.0
4.0
2.0
1.0
0.8
0.6
0.4
0.2
Diffusion controlled
Reaction controlled
F1 *
∠ -3/2
HCl increase
× 1/11
Diffusion controlled
Reaction controlled
0.7
0.8
0.9
1000/K
Log G.R. (um/min)

Fig.8

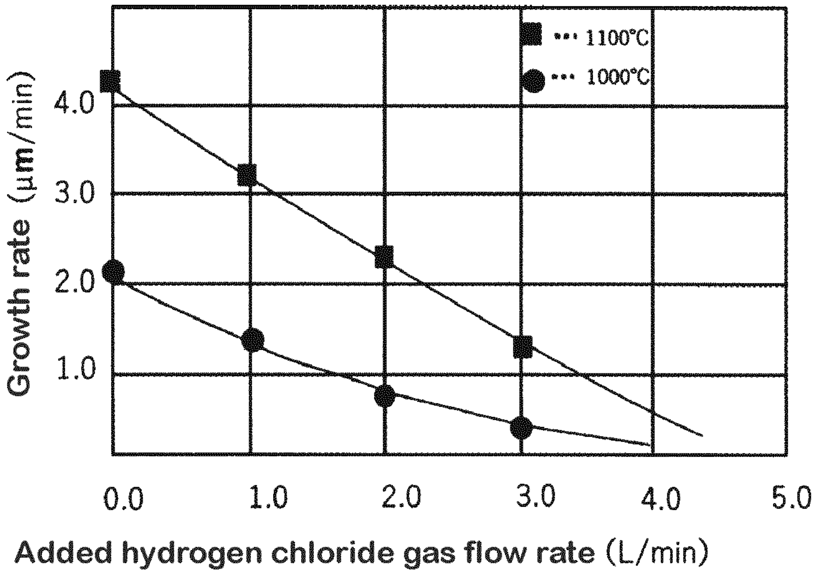


Fig.9

Flow chart of trench filling selective epitaxial growth

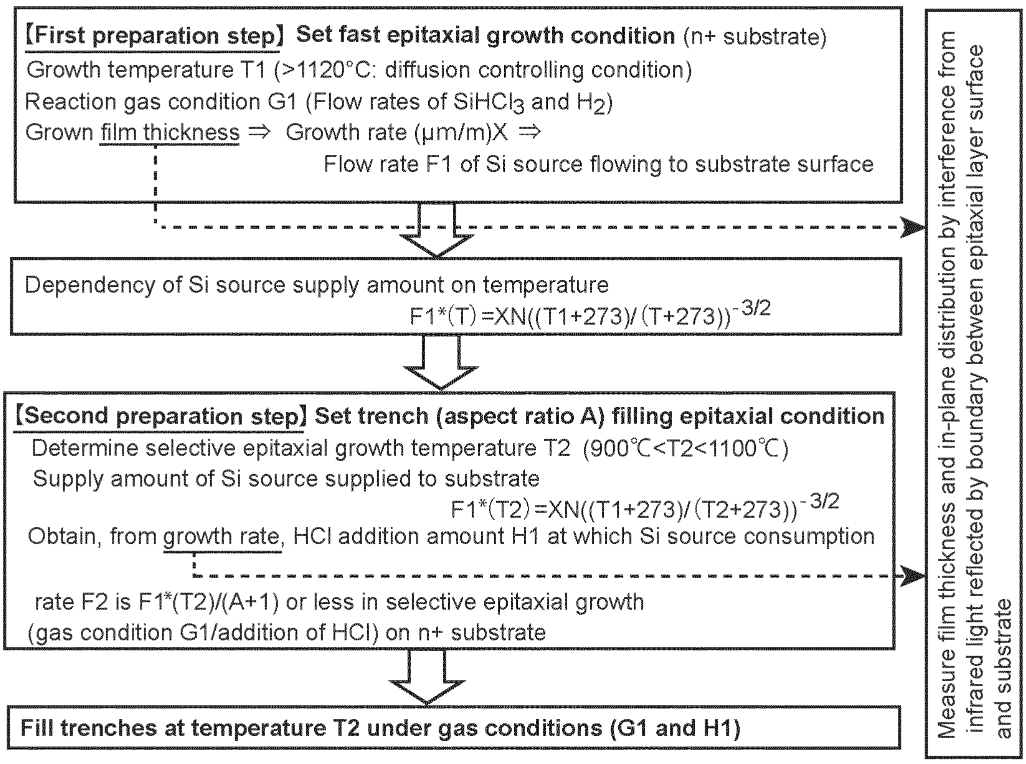


Relationships of growth rate v to F1 and F2 can be approximated as $F1=vN \approx hG \cdot CG$ (diffusion controlled) and $F2=vN \approx kS \cdot CS$ (reaction controlled).
N: atomic density of Si crystal

Fig.10

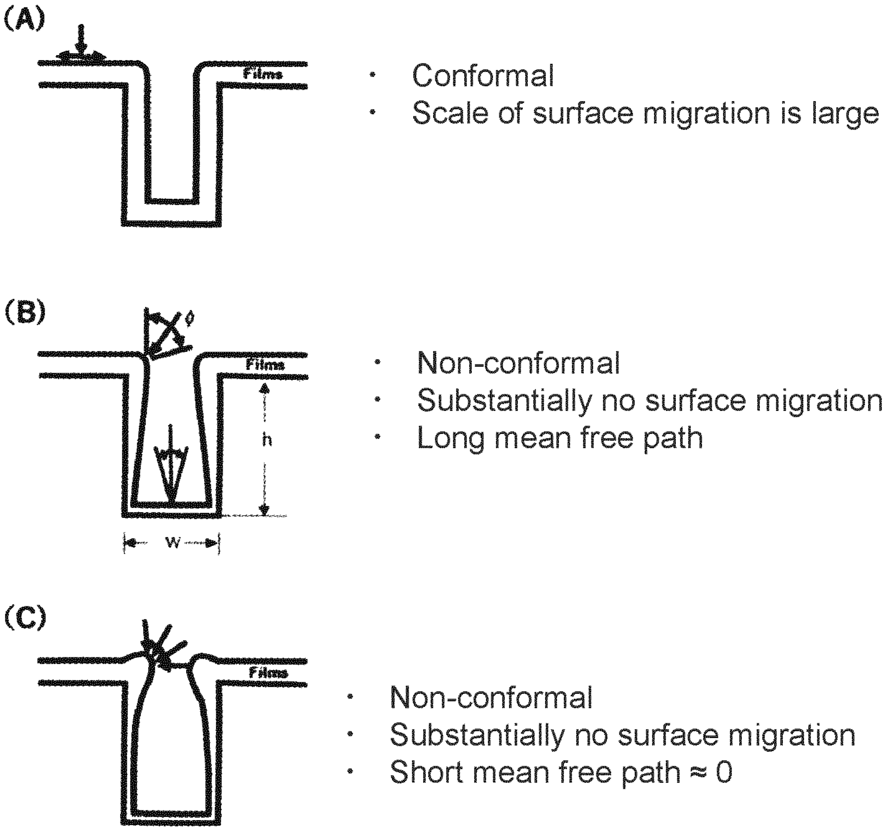


Fig.11

**HCl during filling epitaxial growth**

TCS+HCl+$H_2$/Effect of addition of hydrogen chloride gas

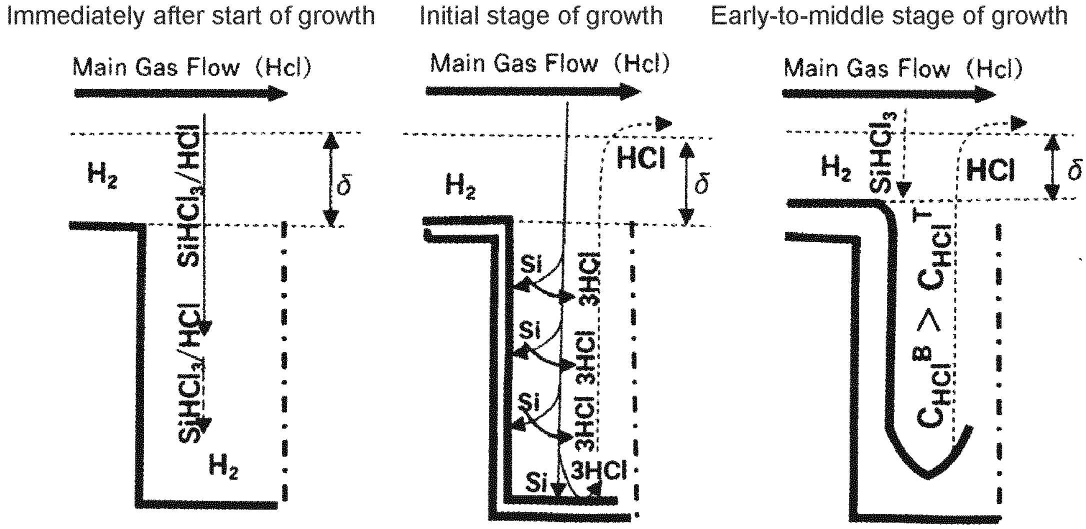

Fig.12

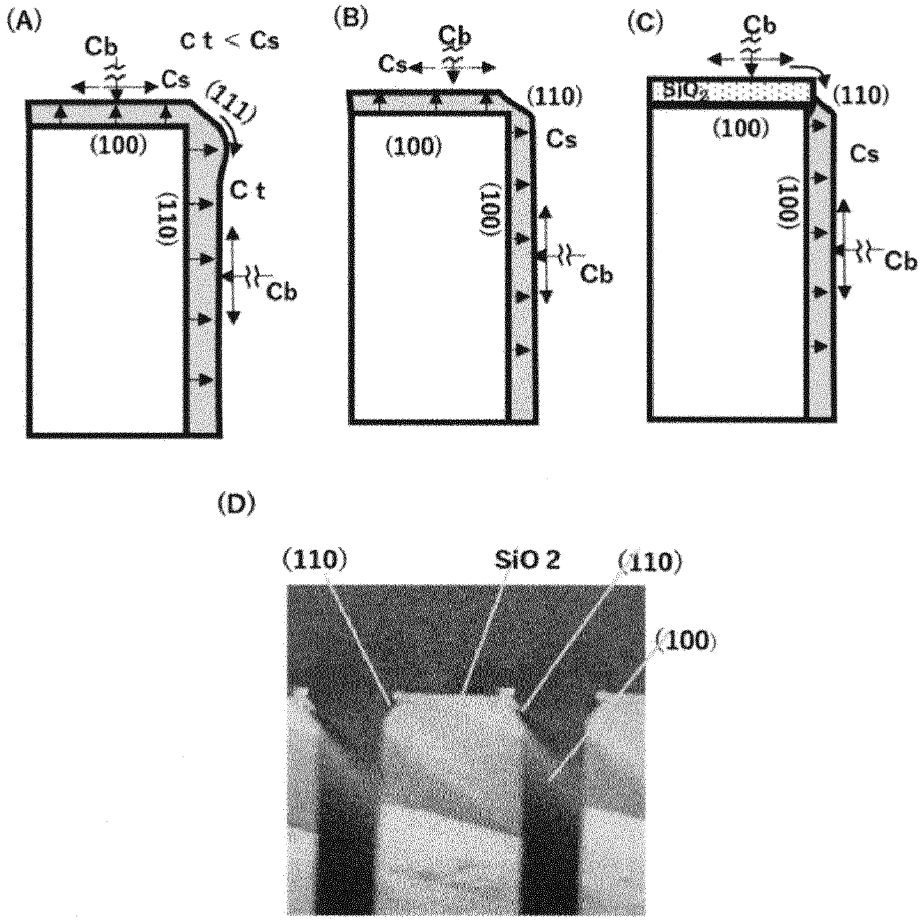
(A)
Cb
C t < Cs
Cs
(111)
(100)
C t
(110)
Cb
(B)
Cb
Cs
(110)
(100)
Cs
(100)
Cb
(C)
Cb
SiO2
(110)
(100)
Cs
(100)
Cb
(D)
(110)
SiO 2
(110)
(100)

Fig.13

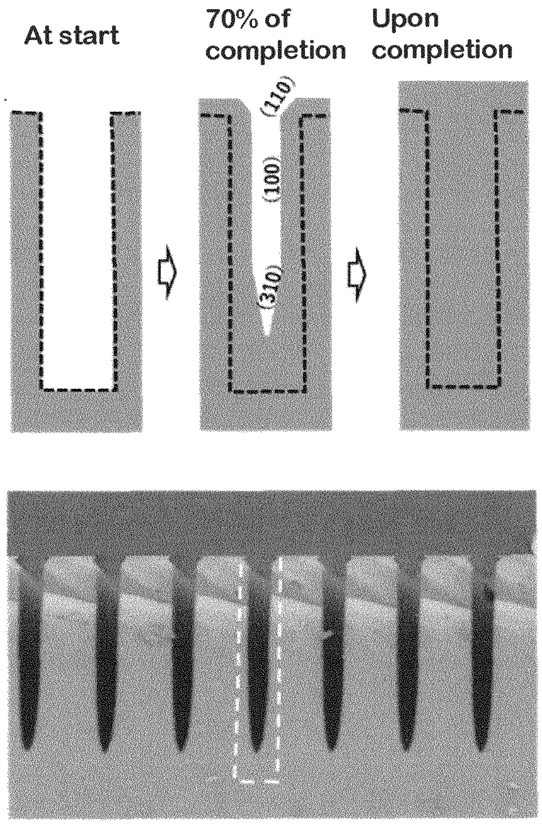
At start
70% of completion
Upon completion
(110)
(100)
(310)

Fig.14

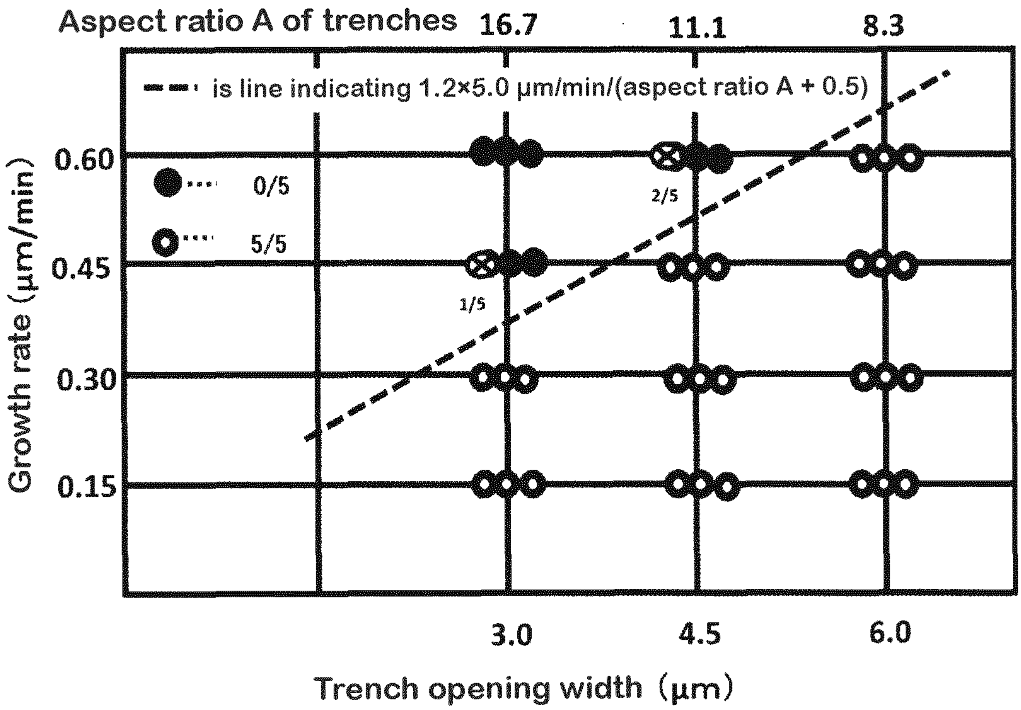
Aspect ratio A of trenches
16.7
11.1
8.3
is line indicating 1.2×5.0 μm/min/(aspect ratio A + 0.5)
0/5
5/5
2/5
1/5
0.60
0.45
0.30
0.15
Growth rate (μm/min)
3.0
4.5
6.0
Trench opening width (μm)

**INTERNATIONAL SEARCH REPORT**

International application No.
**PCT/JP2023/027740**

**A. CLASSIFICATION OF SUBJECT MATTER**

***H01L 29/78***(2006.01)i; ***H01L 21/205***(2006.01)i; ***H01L 21/336***(2006.01)i
FI: H01L29/78 652H; H01L21/205; H01L29/78 658E

According to International Patent Classification (IPC) or to both national classification and IPC

**B. FIELDS SEARCHED**

Minimum documentation searched (classification system followed by classification symbols)

H01L29/78; H01L21/205; H01L21/336

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2007-96139 A (DENSO CORP.) 12 April 2007 (2007-04-12) entire text, all drawings | 1-6 |
| A | JP 2009-224606 A (SHIN ETSU HANDOTAI CO., LTD.) 01 October 2009 (2009-10-01) entire text, all drawings | 1-6 |
| A | JP 2009-231308 A (SHIN ETSU HANDOTAI CO., LTD.) 08 October 2009 (2009-10-08) entire text, all drawings | 1-6 |
| A | JP 2012-169391 A (SUMCO CORP.) 06 September 2012 (2012-09-06) entire text, all drawings | 1-6 |
| A | JP 2014-112594 A (DENSO CORP.) 19 June 2014 (2014-06-19) entire text, all drawings | 1-6 |
| A | JP 2019-140258 A (FUJI ELECTRIC CO., LTD.) 22 August 2019 (2019-08-22) entire text, all drawings | 1-6 |
| A | US 2013/0105796 A1 (LIU, Jiquan) 02 May 2013 (2013-05-02) entire text, all drawings | 1-6 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 October 2023** | **10 October 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/027740**

| Patent document cited in search report | Publication date (day/month/year) | Patent family member(s) | Publication date (day/month/year) |
|---|---|---|---|
| JP 2007-96139 A | 12 April 2007 | US 2007/0072398 A1<br>entire text, all drawings<br>DE 102006045912 A1<br>DE 102006062821 B4<br>KR 10-2007-0036714 A<br>KR 10-2007-0110476 A<br>KR 10-2008-0044805 A<br>CN 101345196 A | |
| JP 2009-224606 A | 01 October 2009 | (Family: none) | |
| JP 2009-231308 A | 08 October 2009 | (Family: none) | |
| JP 2012-169391 A | 06 September 2012 | (Family: none) | |
| JP 2014-112594 A | 19 June 2014 | (Family: none) | |
| JP 2019-140258 A | 22 August 2019 | US 2019/0252517 A1<br>entire text, all drawings | |
| US 2013/0105796 A1 | 02 May 2013 | CN 103094067 A<br>entire text, all drawings | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3915984 B
- JP 4773716 B
- JP 4879545 B
- JP 5072221 B
- JP 5702622 B


### Non-patent literature cited in the description


- **S. YAMAUCHI**. *Proc. ISPSD*, 2001, 363